# EUROPEAN PATENT SPECIFICATION

(11) **EP 2 690 193 B1**
(45) Date of publication and mention of the grant of the patent: **08.05.2019**
(21) Application number: 12763198.4
(22) Date of filing: 23.03.2012
(51) Int. Cl.: C23C 16/44, C23C 16/455, B08B 1/04

(54) **METHOD FOR CLEANING GAS CONVEYING DEVICE AND REACTION DEVICE FOR FILM GROWTH COMPRISING SAID GAS CONVEYING DEVICE**
VERFAHREN ZUM REINIGEN EINER GASFÖRDERVORRICHTUNG SOWIE REAKTIONSVORRICHTUNG ZUR FILMZÜCHTUNG MIT DIESER GASFÖRDERVORRICHTUNG
PROCÉDÉ DE NETTOYAGE D'UN DISPOSITIF DE TRANSPORT DE GAZ ET DISPOSITIF DE RÉACTION POUR UNE CROISSANCE DE FILM COMPRENANT LEDIT DISPOSITIF DE TRANSPORT DE GAZ

(30) Priority: 25.03.2011 CN 201110073624
(43) Date of publication of application: 29.01.2014
(73) Proprietor: Advanced Micro-Fabrication Equipment Inc, Shanghai, Shanghai 201201 (CN)
(72) Inventor: DU, Zhiyou, Shanghai 201201 (CN); ARAMI, Junichi, Shanghai 201201 (CN); SUN, Yijun, Shanghai 201201 (CN)
(74) Representative: Epping - Hermann - Fischer
(86) International application number: PCT/CN2012/072873
(87) International publication number: WO 2012/130089

(56) References cited:
- CN-A- 101 097 844
- CN-A- 102 251 228
- US-A- 5 330 577
- US-A- 5 589 001
- US-A1- 2010 122 710
- US-B1- 6 286 525

## Description

### FIELD OF THE INVENTION

The present application relates to a device and method for film growth, and in particular to a film growth reaction device, a film growth method, and a method for cleaning a gas conveying device in the film growth reaction device.

### BACKGROUND OF THE INVENTION

As a kind of typical group III and group V element compound films, gallium nitride (GaN) is a material widely used to manufacture a blue light emitting diode, a purple light emitting diode, a white light emitting diode, an ultraviolet detector and a high power microwave transistor. Since GaN has practical and potential applications in manufacturing low energy consumption devices (such as an LED) which are widely used, GaN film growth has attracted great attention.

The GaN film may grow with various methods, including a molecular beam epitaxy (MBE) method, a hydride vapor phase epitaxy (HVPE) method, a metal organic chemical vapor deposition (MOCVD) method and so on. At present, the MOCVD method is a preferred deposition method for obtaining a film with enough quality used for the manufacture of an LED.

The MOCVD process is generally performed in a reactor or a reaction chamber at a relatively high temperature by a thermal processing method. Generally, a first precursor gas including a group III element (such as gallium (Ga)) and a second precursor gas (such as ammonia (NH₃)) including nitrogen are fed into the reaction chamber by a gas conveying device to react so as to form a GaN film on a heated substrate. A carrier gas may also be used to assist the transportation of the precursor gases onto the substrate. A group III nitride film (such as a GaN film) is formed by the mixed reaction of the precursor gases on a heated surface of the substrate and then is deposited on the surface of the substrate.

However, during the MOCVD film growth process, the GaN film or other reaction products are not only grown or deposited on the substrate, but also grown or deposited on the inner surface of the reaction chamber including the surface of the gas conveying device. These undesired deposits or residues are accumulated, which may produce adhered aggregates such as powder and particles in the reaction chamber, and may peel off from the adhering surface to spread everywhere in the reaction chamber along with the flow of the reaction gases and to finally fall on the processed substrate, thereby causing defects or ineffective of the substrate and contamination in the reaction chamber which has adverse effects on the quality of the next MOCVD process. Thus, after the MOCVD film growth process is performed for a period of time, the film growth process has to be stopped to specially carry out a cleaning process for the reaction chamber, i.e. to remove the aggregates adhered to the gas conveying device.

At present, the method for cleaning the gas conveying device in the art is "manual cleaning". That is, an operator must stop the film growth process, open a top cover of the reaction chamber after the temperature in the reaction chamber is reduced to a certain temperature, manually brush away the deposits or residues adhered to the gas conveying device from the adhering surface with a brush, and remove them to the outside of the reaction chamber by a vacuum suction method. If the deposits or residues are very thick, the operator needs to manually scrape off them from the adhering surface with a tool and remove them to the outside of the reaction chamber. This cleaning method has some disadvantages. Specifically, for performing the cleaning process, the film growth process needs to be stopped, and it has to wait for a quite long time allowing the temperature in the reaction chamber to be reduced to a suitable temperature for the manual cleaning, and it has to be manually performed by the operator under the condition that the top cover of the reaction chamber is opened. Thus, for a user of the reaction chamber, the throughput of the process production of the reaction chamber is reduced, and the use cost of the producer is increased. Further, due to the "manual cleaning", it is impossible to realize automatic cleaning process of the system, and to ensure the consistent results of cleaning process, causing that deviations and defects in process quality may occur in the subsequent film growth process.

US 5,589,001 A discloses an apparatus for forming a film by the CVD method allows reaction products to be easily removed from a gas discharge surface without decreasing the uptime/downtime ratio, and includes a gas distributor having a gas discharge surface for discharge of a reaction gas for forming a film on a substrate. A wafer holder has a wafer mounting surface facing the gas discharge surface. A cleaner has a suction head and a brush formed at the entrance of the suction head. A rotary shaft supports the cleaner for movement between the gas discharge surface and a stand-by position and brings the brush of the cleaner onto the gas discharge surface. A vertical positioner moves the wafer holder or gas distributor upward or downward, whereby the wafer holder approaches the gas discharge surface for forming a film and is spaced from the gas discharge surface when cleaning the gas discharge surface by movement of the cleaner on the gas discharge surface.

US 5,330,577 A discloses a semiconductor fabrication apparatus for forming a film on a wafer by a CVD method provides for easy removal of the dust generated in a film-forming chamber without reducing the uptime/downtime ratio of the equipment. The apparatus includes one or more gas dispersing devices having gas releasing surfaces for releasing a reaction gas to form a film on a wafer; one or more wafer holders having wafer mounting surfaces opposed to the plane defined by the gas releasing surface; and one or more cleaners, each having a suction port and a brush connected to the suction port, provided opposing the gas releasing surface. Either the cleaner or the gas dispersing device is moved so that the brush contacts and traverses the gas releasing surface.

Therefore, there is a need to develop a device and method for cleaning the gas conveying device and the inner surface of the reaction chamber, which is highly automatic, effective and timesaving, and may ensure the quality and consistency of cleaning, and does not have adverse effects on the subsequent film growth.

### SUMMARY OF THE INVENTION

In view of the above problems in the prior art, an object of the present application is to provide a device and method for in-situ cleaning a gas conveying device in a film growth reaction chamber in a highly automatic, effective and timesaving manner.

Another object of the present application is to provide a method for film growth.

Yet another object of the present application is to provide a reaction device for film growth on a substrate.

Still another object of the present application is to provide a cleaning device for cleaning a gas conveying device.

A further object of the present application is to provide a method and device for removing adhered aggregates on the inner surface of the film growth reaction chamber. The present invention solves the problems above by a method according to claim 1 and an apparatus according to claim 11.

According to one aspect of the present application, a method for cleaning a gas conveying device in a film growth reaction chamber is provided, wherein the gas conveying device includes a gas conveying surface for releasing reaction gases into the reaction chamber, and a supporting device is provided in the reaction chamber. The method includes:
a) unloading a substrate carrier after a film growth process is finished, wherein the substrate carrier is located in the reaction chamber and is detachably mounted on the supporting device, and wherein in the step of unloading the substrate carrier, the substrate carrier is detached from the supporting device and is moved out of the reaction chamber;
b) providing a cleaning device and moving the cleaning device into the reaction chamber, and detachably mounting the cleaning device on the supporting device, wherein the cleaning device includes a surface facing the gas conveying surface and provided with a plurality of scraping structures thereon; and
c) adjusting position of the cleaning device such that the scraping structures at least partially contact with the gas conveying surface of the gas conveying device, and rotating the cleaning device such that the scraping structures contact with the gas conveying surface and remove adhered aggregates adhered to the gas conveying surface.

The method further includes: providing a rotary driving device connected to the supporting device, and starting the rotary driving device to drive the supporting device and the cleaning device to rotate together.

The film growth reaction chamber is a film epitaxial growth reaction chamber.

The method further includes: providing a suction port in fluid communication with the inside of the reaction chamber, wherein the suction port is connected to an air exhaust pump or a blower; and operating the air exhaust pump or the blower to perform a suction function.

The suction port is provided in a bottom portion or a side wall of the reaction chamber.

The suction port is provided in a side wall of the reaction chamber, and located in a horizontal space formed by the gas conveying surface and the surface of the cleaning device and adjacent to the scraping structures of the cleaning device.

The method further includes: providing an aggregate collecting device in fluid communication with the suction port to collect the adhered aggregates.

An aggregate collecting device in fluid communication with the suction port is provided inside the cleaning device to collect the adhered aggregates.

The supporting device also acts as a supporting device for carrying a substrate carrier in the reaction chamber.

The supporting device includes a rotatable shaft having a supporting end or a supporting surface.

The cleaning device further includes a connecting surface on which a concave portion is provided, and the supporting end of the rotatable shaft is detachably received in the concave portion.

The supporting device includes a rotation shaft main body and at least three supporting ends extending outwards from the rotation shaft main body, with the at least three supporting ends collectively supporting the cleaning device.

The supporting device includes a first supporting member and a second supporting member connected to the first supporting member. The second supporting member supports the cleaning device, and the rotary driving device is connected to the first supporting member and drives the first supporting member and the second supporting member to move together.

The supporting device includes a first supporting member and a second supporting member collectively supporting the cleaning device, and the rotary driving device is connected to the first supporting member and drives the first supporting member and the second supporting member to move together.

A substrate carrier is further provided in the reaction chamber. The substrate carrier is configured to convey and support the substrate, is detachably mounted on the supporting device and contacts with the supporting device at least during the film growth process performed in the reaction chamber, and can be easily removed from the supporting device so as to be conveyed for loading or unloading the substrate.

A connecting portion between the cleaning device and the supporting device has the same structure and size as those of the connecting portion between the substrate carrier and the supporting device.

The scraping structures are bristle structures, or ridged scraping blade structures, or a combination thereof.

The gas conveying device is a gas distribution showerhead device, or an injector-type gas dispersing device, or a combination thereof.

The rotary driving device includes a motor.

The method further includes: providing a mechanical conveying device located outside the reaction chamber, wherein the mechanical conveying device includes a conveying robot, the conveying robot is configured to selectively convey the cleaning device into the reaction chamber from the outside of the reaction chamber and place the cleaning device onto the supporting device, or remove the cleaning device from the supporting device and convey the cleaning device to the outside of the reaction chamber.

Step b) further includes the step of blowing inert gases or H₂ into the reaction chamber via the gas conveying surface of the gas conveying device.

According to another aspect of the present application, a method for film growth in a reaction chamber is provided, wherein a supporting device having a supporting end or a supporting surface is provided in the reaction chamber. The method comprises the steps a), b) and c) according to the first embodiment and the method further comprises steps a'), b'), and c') performed before the steps a), b) and c)::
a') providing a substrate carrier on which one or more substrates to be processed is loaded;
b') moving the substrate carrier into the reaction chamber and detachably mounting the substrate carrier on the supporting end or the supporting surface of the supporting device;
c') feeding reaction gases into the reaction chamber by a gas conveying device and rotating the supporting device and the substrate carrier for film growth on the substrate; wherein the method further comprises a step d') performed after the steps a), b) and c)
d') stopping rotating the supporting device and cleaning device, and detaching the cleaning device from the supporting end or the supporting surface of the supporting device and moving the cleaning device out of the reaction chamber.

Step c) further includes: providing a suction port in fluid communication with the inside of the reaction chamber, wherein the suction port is connected to an air exhaust pump or a blower; and operating the air exhaust pump or the blower to perform a suction function.

Step c) further includes: blowing inert gases or H₂ into the reaction chamber via the gas conveying surface of the gas conveying device.

The method further includes: providing an aggregate collecting device in fluid communication with the suction port to collect the adhered aggregates.

An aggregate collecting device in fluid communication with the suction port is provided inside the cleaning device to collect the adhered aggregates.

The supporting device is a rotatable shaft having the supporting end or the supporting surface.

The cleaning device further includes a connecting surface, and a concave portion is provided at the center area of the connecting surface, with the supporting end of the rotatable shaft being detachably received in the concave portion.

The supporting device includes a first supporting member and a second supporting member connected to the first supporting member. The second supporting member supports the cleaning device, and the first supporting member is connected to a rotary driving device which drives the first supporting member and the second supporting member to move together.

The supporting device includes a first supporting member and a second supporting member collectively supporting the cleaning device, and the first supporting member is connected to a rotary driving device which drives the first supporting member and the second supporting member to move together.

A connecting portion between the cleaning device and the supporting device has the same structure and size as those of the connecting portion between the substrate carrier and the supporting device.

The scraping structures are bristle structures, or ridged scraping blade structures, or a combination thereof.

The gas conveying device is a gas distribution showerhead device, or an injector-type gas dispersing device, or a combination thereof.

Step g) includes: providing a rotary driving device connected to the supporting device; starting the rotary driving device to drive the supporting device and the cleaning device to rotate together.

The method further includes: providing a mechanical conveying device located outside the reaction chamber, wherein the mechanical conveying device includes a conveying robot, the conveying robot is configured to selectively convey the cleaning device or the substrate carrier into the reaction chamber from the outside of the reaction chamber and place the cleaning device or the substrate carrier onto the supporting device, or remove the cleaning device or the substrate carrier from the supporting device and convey the cleaning device or the substrate carrier to the outside of the reaction chamber.

During the process of implementing the method, the reaction chamber cover of the reaction chamber remains in a closed state.

According to a further aspect of the present application, a reaction device for film growth on a substrate is further provided, including:
a reaction chamber;
a gas conveying device provided in the reaction chamber and including a gas conveying surface for releasing reaction gases into the reaction chamber to form a compound film on the substrate;
a supporting device provided in the reaction chamber;
a substrate carrier configured to be mounted on the supporting device, wherein the substrate carrier is configured to support and load the substrate into the reaction chamber before a film growth process, and the substrate carrier is configured to be removed from the supporting device so as to be conveyed out of the reaction chamber before a cleaning process;
a cleaning device configured to be detachably mounted on the supporting device during the cleaning process, wherein the cleaning device is configured to be removed from the supporting device and moved out of the reaction chamber, and the cleaning device includes a surface facing the gas conveying surface and provided with a plurality of scraping structures; and
a rotary driving device configured to selectively drive the plurality of scraping structures on the cleaning device to rotate;
wherein the cleaning device may be located in the reaction chamber at a position where at least part of the plurality of scraping structures contact with the gas conveying surface, and remove adhered aggregates adhered on the gas conveying surface.

The reaction device further includes a suction port in fluid communication with the inside of the reaction chamber, wherein the suction port is connected to an air exhaust pump or a blower.

The suction port is provided in a bottom portion or a side wall of the reaction chamber.

The suction port is provided in a side wall of the reaction chamber, and located in a horizontal space formed by the gas conveying surface and the surface of the cleaning device and adjacent to the scraping structures of the cleaning device.

The reaction device further includes an aggregate collecting device in fluid communication with the suction port to collect the adhered aggregates.

An aggregate collecting device in fluid communication with the suction port is provided inside the cleaning device to collect the adhered aggregates.

A connecting portion between the cleaning device and the supporting device has the same structure and size as those of the connecting portion between the substrate carrier and the supporting device.

The scraping structures are bristle structures, or ridged scraping blade structures, or a combination thereof.

The supporting device is a rotatable shaft having at least a supporting end or a supporting surface.

Each of the substrate carrier and the cleaning device includes a connecting surface, and a concave portion is provided at the center area of each of the two connecting surfaces, with the supporting end of the rotatable shaft is detachably received in the central concave portions of the substrate carrier and the cleaning device.

The supporting device includes a rotation shaft main body and at least three supporting ends extending outwards from the rotation shaft main body, with the at least three supporting ends collectively supporting the cleaning device.

The supporting device includes a first supporting member and a second supporting member connected to the first supporting member. The second supporting member supports the cleaning device, and the first supporting member is connected to a rotary driving device which drives the first supporting member and the second supporting member to move together.

The supporting device includes a first supporting member and a second supporting member collectively supporting the cleaning device, and the first supporting member is connected to a rotary driving device which drives the first supporting member and the second supporting member to move together.

The gas conveying device is a gas distribution showerhead device, or an injector-type gas dispersing device, or a combination thereof.

The rotary driving device is a motor.

The reaction device further includes a mechanical conveying device located outside the reaction chamber, wherein the mechanical conveying device includes a conveying robot, the conveying robot is configured to selectively convey the cleaning device or the substrate carrier into the reaction chamber from the outside of the reaction chamber and place the cleaning device or the substrate carrier onto the supporting device, or remove the cleaning device or the substrate carrier from the supporting device and convey the cleaning device or the substrate carrier to the outside of the reaction chamber.

The cleaning device further includes a barrier device provided in the peripheral of the plurality of scraping structures and encircling the plurality of scraping structures.

A barrier device is further provided in the reaction chamber, and the barrier device is provided adjacent to the peripheral of the gas conveying device and encircles the plurality of scraping structures of the cleaning device.

The cleaning device further includes a second surface facing an inner side wall of the reaction chamber, and a plurality of scraping structures are provided on the second surface. According to yet another aspect of the present application, a method for removing adhered aggregates on inner surfaces of a film growth reaction chamber is further provided, wherein a supporting device is provided in the reaction chamber. The method includes:
a) providing a cleaning device and detachably mounting the cleaning device on the supporting device, wherein the cleaning device includes one or more surfaces facing the inner surfaces of the reaction chamber and provided with a plurality of scraping structures thereon; and
b) adjusting position of the cleaning device such that the scraping structures at least partially contact with the inner surfaces of the reaction chamber, and rotating the cleaning device such that the scraping structures contact with the inner surfaces of the reaction chamber and remove the adhered aggregates adhered to the inner surfaces of the reaction chamber.

The inner surface of the reaction chamber includes an inner side wall of the reaction chamber and /or a gas conveying surface of a gas conveying device.

### BRIEF DESCRIPTION OF THE DRAWINGS

Figure 1 is a schematic view of a film growth device in the prior art;
Figure 2a shows a device for implementing the cleaning method of the present application according to an embodiment of the present application;
Figure 2b is a schematic view of the process of cleaning a gas conveying device by the device as shown in Fig. 2a;
Figures 3a and 3b are perspective schematic views of the cleaning device in Figures 2a and 2b;
Figure 4 shows an embodiment of a supporting device;
Figure 5a is a perspective schematic view of an assembly of the cleaning device and the supporting device;
Figure 5b is a cross-sectional schematic view of the cleaning device and the supporting device taken along a certain cross section line;
Figure 6 is a perspective schematic view of another embodiment of a supporting device;
Figures 7a and 7b are respectively a perspective schematic view and a cross-sectional schematic view illustrating the assembly of another embodiment of the cleaning device and the supporting device as shown in Figure 6;
Figures 8a, 8b and 8c are schematic views respectively illustrating the assembly of the above cleaning device and another embodiment of the supporting device;
Figure 9a is a schematic view illustrating another device for cleaning the gas conveying device according to the present application as well as the cleaning process;
Figures 9b and 9c are respectively a perspective schematic view and a cross-sectional schematic view of the cleaning device in Figure 9a;
Figure 10 shows a variation of the cleaning device as shown in Figure 9b;
Figure 11a is a schematic view illustrating another device for cleaning the gas conveying device according to the present application as well as the cleaning process;
Figures 11b and 11c are respectively a perspective schematic view and a cross-sectional schematic view of the cleaning device in Figure 11a;
Figure 12 is a schematic view illustrating another device for cleaning a gas conveying device according to the present application as well as the cleaning process;
Figure 13a is a schematic view illustrating another device for cleaning a gas conveying device according to the present application as well as the cleaning process;
Figures 13b and 13c are respectively a perspective schematic view and a cross-sectional schematic view of the cleaning device in Figure 13a;
Figure 14 is a schematic view illustrating another device for cleaning a gas conveying device according to the present application as well as the cleaning process;
Figure 15 is a schematic view illustrating the process of cleaning a gas conveying device by another cleaning device according to the present application;
Figure 16 shows another embodiment of the cleaning device according to the present application; and
Figure 17 is a schematic view illustrating a device for removing adhered aggregates on the inner surface of the film growth reaction chamber according to the present application as well as the removing process.

### DETAILED DESCRIPTION OF THE EMBODIMENTS

The present application will be described in detail in conjunction with drawings and embodiments hereinafter.

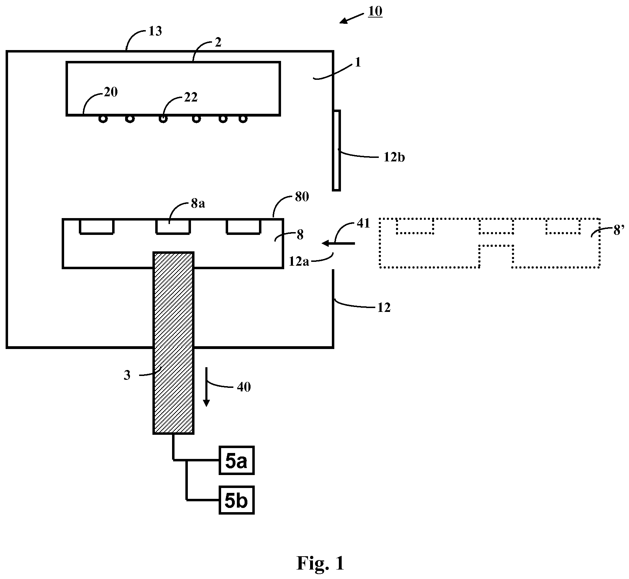

Fig. 1 is a schematic view of a film growth device in the prior art. The film growth device 10 includes a film growth reaction chamber 1 configured to epitaxially grow various compound films or deposit various deposited products, such as a group III and group V element compound film, on a substrate 8a therein. In particular, as shown in Fig. 1, the reaction chamber 1 includes a side wall 12, a gas conveying device 2 provided in the reaction chamber 1, and a substrate carrier 8. The gas conveying device 2 includes a gas conveying surface 20 for releasing reaction gases into the reaction chamber 1. The reaction chamber 1 further includes a supporting device 3 for supporting the substrate carrier 8. The supporting device 3 is generally connected to a rotary driving device 5a which may selectively drive the supporting device 3 and the substrate carrier 8 to rotate. Preferably, the rotary driving device 5a includes an electric motor. Optionally, the supporting device 3 is further connected to an elevating driving device 5b configured to adjust a height of the supporting device 3 in the reaction chamber. Optionally, a substrate conveying opening 12a and a valve 12b for closing and opening the substrate conveying opening 12a may be provided on the side wall 12 of the reaction chamber 1, as needed. Before preparing the film growth process, a plurality of substrates 8a to be processed are preloaded onto the substrate carrier 8 outside the reaction chamber 1, and then the substrate carrier 8 loaded with the substrates is conveyed into the reaction chamber 1 from the outside of the reaction chamber 1 through the substrate conveying opening 12a manually or by a conveying robot, and is placed on the supporting device 3 so as to perform the subsequent film growth process. After the film growth process is finished, the substrate carrier 8 loaded with the plurality of substrates 8a is conveyed to the outside of the reaction chamber 1 through the substrate conveying opening 12a and then the substrates 8a are unloaded from the substrate carrier 8.

Before performing the film growth process, the elevating driving device 5b is actuated firstly to adjust the height of the supporting device 3 in the reaction chamber 1 (in the direction indicated by the arrow 40), such that the supporting device 3 reaches a position corresponding to the substrate conveying opening 12a; then the valve 12b is shifted to open the substrate conveying opening 12a; the substrate carrier 8' preloaded with a plurality of substrates to be processed is conveyed into the reaction chamber 1 by an appropriate method and is placed on a supporting end 3a of the supporting device 3; then the valve 12b is closed; and the elevating driving device 5b is actuated to raise the height of the supporting device 3 (along the reverse direction indicated by the arrow 40) such that the substrate carrier 8 may have an appropriate distance from the gas conveying device 2. Next, the rotary driving device 5a is actuated to rotate the supporting device 3, and then the supporting device 3 drives the substrate carrier 8 to rotate together. The gas conveying device 2 supplies reaction gases into the reaction chamber 1 via a gas conveying surface 20 thereof so as to grow film on the substrates 8a.

After the film growth process is performed in the reaction chamber 1 for a period of time, adhered aggregates, deposits or residues 22 may accumulated on the gas conveying surface 20 of the gas conveying device 2. In the prior art, for cleaning the gas conveying device 2, an operator has to open a top cover 13 of the reaction chamber after the temperature in the reaction chamber 1 is reduced to a certain temperature, and then remove the adhered aggregates, deposits or residues 22 from the gas conveying surface 20 manually.

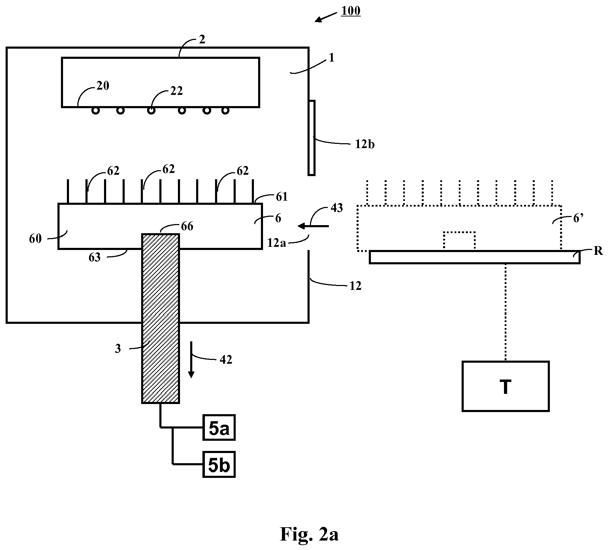

To clean the gas conveying device effectively and automatically, a device 100 as shown in Fig. 2a is provided in the present application. Fig. 2a shows a device 100 for implementing the cleaning method of the present application according to an embodiment of the present application. The device 100 as shown in Fig. 2a may practically service as a part of the reaction device for the film growth as shown in Fig. 1. Thus, many components in Fig. 2a are the same as the components in Fig. 1. For the sake of conciseness, the components in Fig. 2a which are the same as the components in Fig. 1 are denoted by the same reference numbers as in Fig. 1, which also applies to the other Figures of the present application.

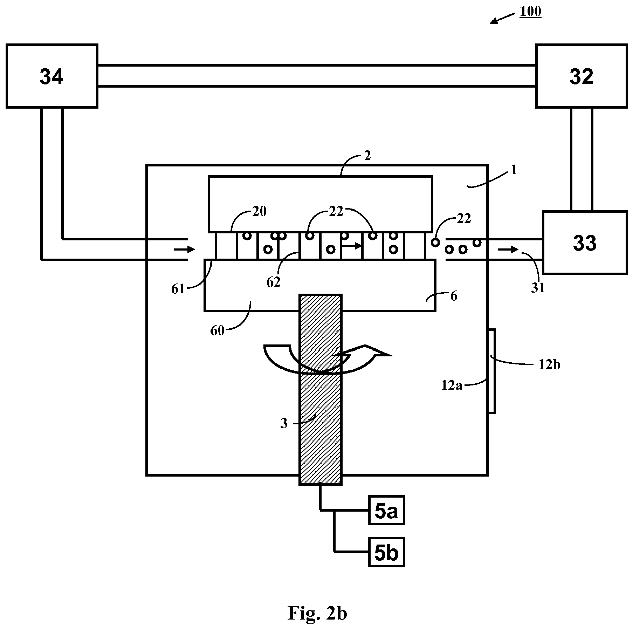

Referring to Figs. 2a and 2b, Fig. 2b is a schematic view of the process of cleaning a gas conveying device by the device as shown in Figs. 2a. In the present application, a cleaning device 6 for cleaning a gas conveying device 2 is provided inside the reaction chamber 1. The cleaning device 6 has a surface 61 facing the gas conveying surface 20 and connected with a plurality of scraping structures 62 thereon. As one example, the plurality of scraping structures 62 as shown in Fig. 2a are an array of bristles. The bristles may be made of various relatively hard materials such as stainless steel, nylon, or relatively hard animal hairs. The cleaning device 6 may be detachably mounted on the supporting device 3, and maintain in contact with and moving together with the supporting device 3 at least during the process of cleaning the gas conveying device 2. The cleaning device 6 can be easily moved into the reaction chamber 1 from the outside of the reaction chamber 1 and detachably mounted on the supporting device 3; and it can also be easily detached from the supporting device 3 and moved out of the reaction chamber 1. As one preferred embodiment, the device 100 further includes a mechanical conveying device T (only schematically shown). The mechanical conveying device T includes a conveying robot R. The conveying robot R of the mechanical conveying device T may be used for performing some actions in automatic manner, for example, to convey the cleaning device 6 into or out of the reaction chamber 1, to mount the cleaning device 6 onto the supporting device 3, and to detach the cleaning device 6 from the supporting device 3.

As described above, after the film growth process is performed for a period of time in the reaction chamber 1 in Fig. 1, the gas conveying device 2 needs to be cleaned. Before performing the cleaning, the plurality of substrates 8a in Fig. 1 firstly need to be unloaded out of the reaction chamber 1 to avoid being contaminated, which may be realized by unloading the substrate carrier 8 loaded with the substrates 8a along the reverse direction of the arrow 41 as shown in Fig. 1 to the outside of the reaction chamber 1. In unloading a substrate carrier, the substrate carrier 8 is detached from the supporting device 3 and then moved out of the reaction chamber 1. Then, referring to Fig. 2a, a cleaning device 6 is provided into the reaction chamber 1 and is detachably mounted on the supporting device 3. The cleaning device 6 may be conveyed into the reaction chamber 1 through the substrate conveying opening 12a along the direction of the arrow 43 by the conveying robot R as shown, and may be further detachably mounted on the supporting device 3. The cleaning device 6 may also be detachably mounted on the supporting device 3 by other ways (e.g., manually). Then the valve 12b of the substrate conveying opening 12a is closed. In the reaction chamber 1, a rotary driving device 5a may be further provided, and is connected to the supporting device 3, and may selectively drive the supporting device 3 and the cleaning device 6 to rotate together. Optionally, the supporting device 3 is further connected to an elevating driving device 5b for adjusting the height of the cleaning device 6 in the reaction chamber 1 along the direction indicated by the arrow 42 or its reverse direction.

Then, referring to Fig. 2b, Fig. 2b is a schematic view of process of cleaning a gas conveying device 2 by the device as shown in Figs. 2a. The elevating driving device 5b is actuated firstly to adjust the height of the cleaning device 6 such that its scraping structures 62 may at least partially contact with the gas conveying surface 20 of the gas conveying device 2. The scraping structures 62 on the cleaning device 6 are rotated, such that the scraping structures 62 of the cleaning device 6 at least partially contact with the gas conveying surface 20 of the gas conveying device 2 and remove the adhered aggregates adhered to the gas conveying surface. A suction port 31 is provided adjacent to the scraping structures 62 and is connected to an air exhaust device (e.g., an air exhaust pump or a blower) 34. The air exhaust device 34 keeps working to form a suction function, so as to suck the removed adhered aggregates 22 from a horizontal space between the gas conveying surface 20 and the surface 61. As one embodiment, in order to rotate the scraping structures 62 on the cleaning device 6, it may be done by actuating the rotary driving device 5a to drive the supporting device 3 and in turn drive the cleaning device 6.

As an exemplary embodiment, a device for implementing the suction process is provided as schematically shown in Fig. 2b. The suction port 31 is provided adjacent to the scraping structures 62. For example, the suction port 31 may be located in a horizontal space formed between the gas conveying surface 20 and the surface 61. The suction port 31 is connected to or in fluid communication with an aggregate collecting device 33 configured to collect the removed adhered aggregates 22. A filter (not shown) may be further provided inside the aggregate collecting device 33. In this way, the suction air flow may enter into the air exhaust pump or the blower 34 after passing through the filter of the aggregate collecting device 33, thereby forming a flow path of the suction air. Optionally, a cooling device 32 may be further provided between the aggregate collecting device 33 and the air exhaust pump or the blower 34 to cool the high-temperature air going past the aggregate collecting device 33, so as to protect the air exhaust pump or the blower 34 from being damaged by overheating.

In Fig. 2b, during the cleaning process of the gas conveying device 2, for improving the cleaning efficiency and preventing the adhered aggregates 22 from entering into gas transportation holes of the gas conveying device 2, inert gases or other gases (such as H₂) may be blown into the reaction chamber 1 via the gas conveying device 2 to blow the adhered aggregates 20 into the horizontal space between the gas conveying surface 20 and the surface 61.

It should be understood that, the above suction port 31 may be arranged at another position as actually needed, as long as the suction port is provided so as to be in fluid communication with the inside of the reaction chamber. For example, the suction port may also be provided at a bottom portion or a side wall of the reaction chamber 1.

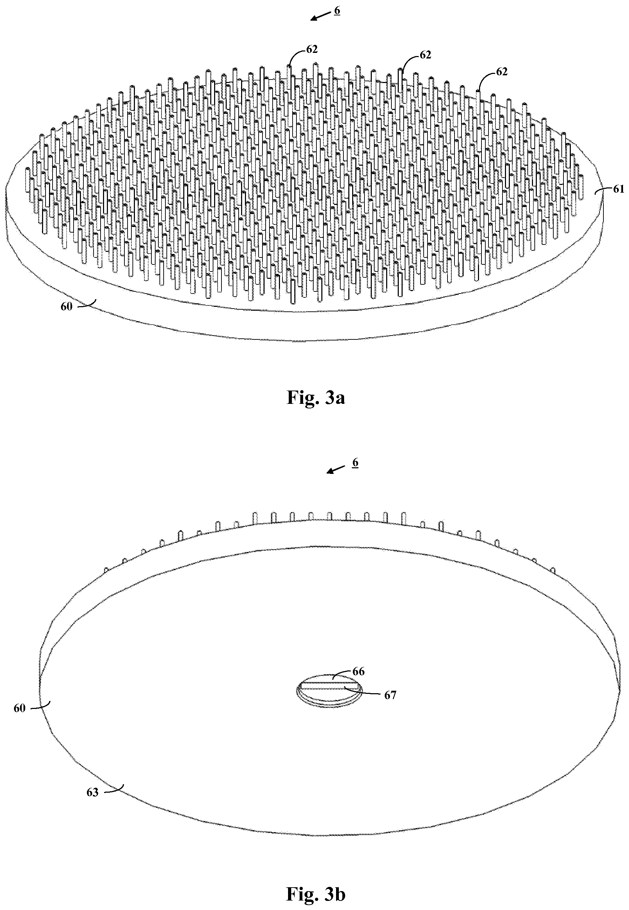

Figs. 3a, 3b are perspective schematic views of the cleaning device 6 as shown in Figs. 2a, 2b. The cleaning device 6 includes a main body 60 which includes a first surface 61 and a second surface 63 acting as a connecting surface. The first surface 61 faces the above gas conveying surface 20, and a plurality of scraping structures 62 are provided on at least part of the area of the first surface 61. A connecting structure (shown as a concave portion 67 schematically) connected with the supporting end or supporting surface of the supporting device 3 (as will be described in detail below) is provided at an appropriate area (for example, a central area) 66 of the second surface 63.

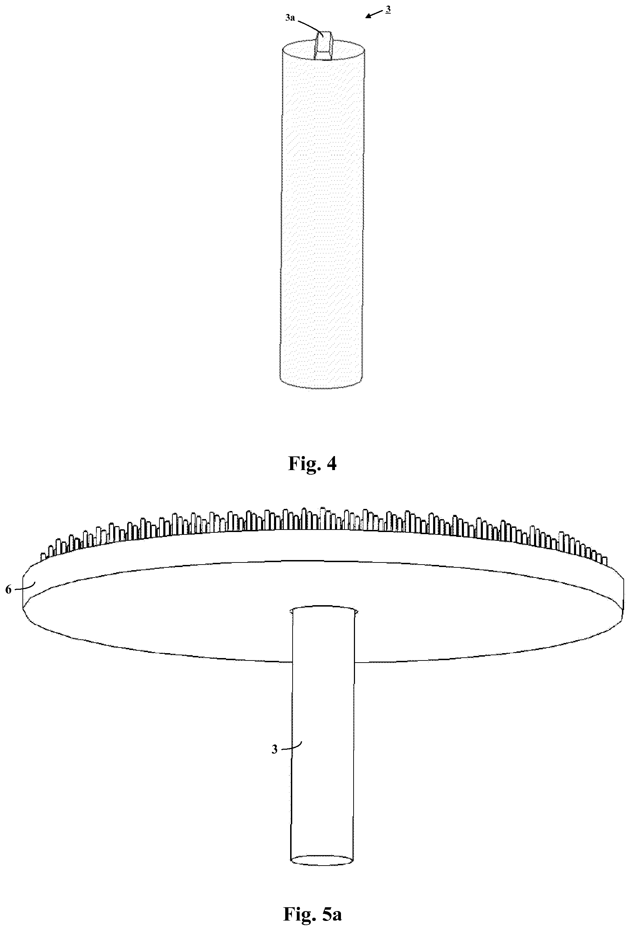

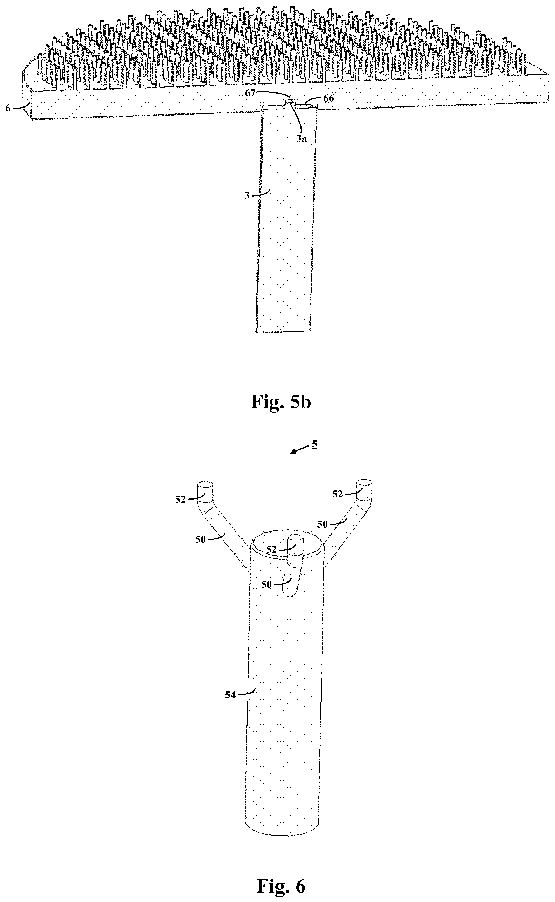

An embodiment of the above supporting device 3 is shown in Fig. 4. In particular, the supporting device is a rotatable shaft having a supporting end 3a. Fig. 5a is a perspective schematic view illustrating the assembly of the cleaning device and the supporting device; Fig. 5b is a cross-sectional schematic view of the cleaning device and the supporting device taken along a certain cross section line. Known from Figs. 5a and 5b, the supporting end 3a of the rotatable shaft 3 is detachably received in the concave portion 67 of the above described cleaning device 6, so as to be connected together and to move together, for example, rotating, rising or falling. According to requirements, the supporting end 3a of the rotatable shaft 3 can also be easily detached from the concave portion 67 of the cleaning device 6, and the cleaning device 6 can be moved out of the reaction chamber 1 from the inside of the reaction chamber 1. Such actions as loading and unloading the cleaning device 6 may be performed by the conveying robot R as shown in Fig. 2a.

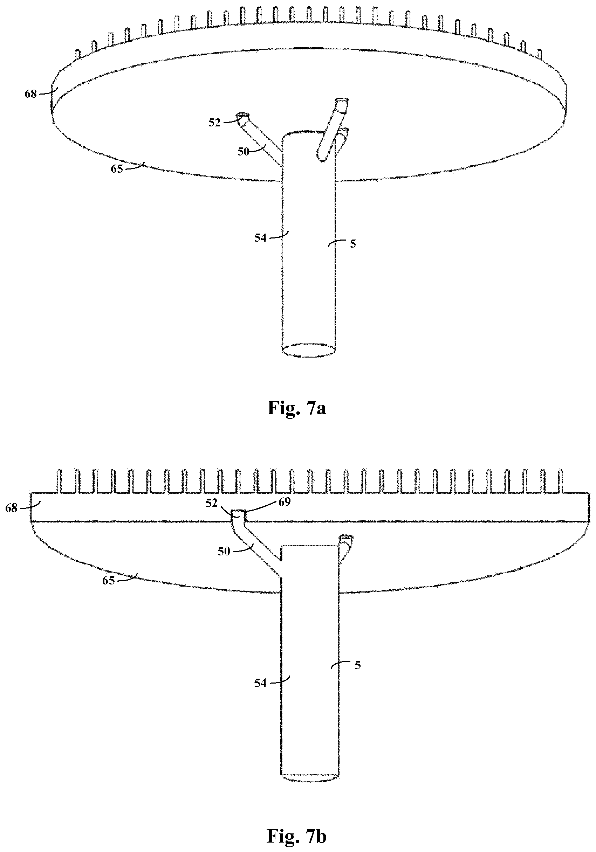

Fig. 6 is a perspective schematic view of another embodiment of a supporting device, and Figs. 7a and 7b are respectively a perspective schematic view and a cross-sectional schematic view illustrating the assembly of another embodiment of the cleaning device and the supporting device as shown in Fig. 6. The supporting device 5 includes a rotation shaft main body 54 and at least three supporting ends 50 extending outwards from the rotation shaft main body 54, with the at least three supporting ends 50 collectively supporting a cleaning device 68. For detachably connecting the supporting device 5 and the cleaning device 68, a supporting end 52 may be further provided at the top of each of the supporting ends 50, and a concave portion 69 is provided on the bottom surface 65 of the cleaning device 68 in such a manner to correspond to the supporting end 52. In this way, each supporting end 52 may be correspondingly and detachably received in the concave portion 69 of the cleaning device 68, such that the cleaning device 68 and the supporting device 5 are connected together and move together, for example, rotating, or rising or falling. As desired, the supporting end 52 of the supporting device 5 can also be easily detached from the concave portion 69 of the cleaning device 68, and the cleaning device 68 may be moved out of the reaction chamber 1 from the inside of the reaction chamber 1. Such actions as loading and unloading the cleaning device 68 may be performed by the conveying robot R as shown in Fig. 2a.

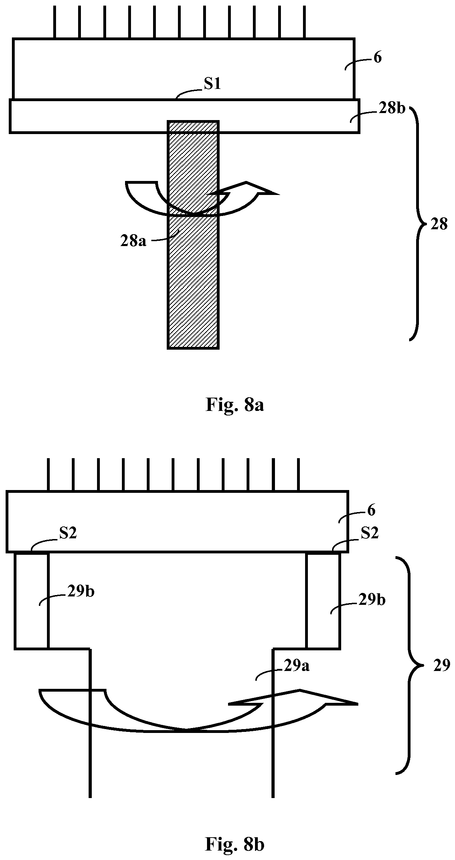

Fig. 8a is a schematic view illustrating the assembly of the above cleaning device and another embodiment of the supporting device. A supporting device 28 as shown in Fig. 8a includes a first supporting member 28a and a second supporting member 28b connected to the first supporting member 28a. The first supporting member 28a and the second supporting member 28b are connected to each other such as to move together (for example, rising or falling vertically, or rotating). The first supporting member 28a and the second supporting member 28b may have connecting structures as described above, so as to be detachably connected, or can be undetachably connected together, for example, being welded together. A rotary driving device (not shown) is connected to the first supporting member 28a, and configured to rotate the first supporting member 28a, and in turn drive the second supporting member 28b to rotate. Similar to the above description, the cleaning device 6 is detachably mounted on the second supporting member 28b of the supporting device 28, and maintains in contact with and moving (for example, rising or falling vertically, or rotating) together with the second supporting member 28b at least during the cleaning process. After the cleaning process is finished, the cleaning device 6 can also be easily detached from the second supporting member 28b and moved out of the reaction chamber 1. For realizing the detachable connecting structure between the cleaning device 6 and the second supporting member 28b, as an embodiment, a snap-fit structure (not shown) may be provided respectively and correspondingly at a proper position on the connecting surface S1 (S1 is also a supporting surface for the supporting device 28) of each of the cleaning device 6 and the second supporting member 28b, such that the cleaning device 6 may be detachably placed on the second supporting member 28b directly and may move together with the second supporting member 28b. Preferably, the above first supporting member 28a is a supporting shaft or a supporting rod; and the above second supporting member 28b is a supporting tray and may be made of stainless steel material, aluminum material or quartz material.

Fig. 8b is a schematic view illustrating the assembly of the above cleaning device and another embodiment of the supporting device. A supporting device 29 as shown in Fig. 8b includes a first supporting member 29a, and a second supporting member 29b provided above the first supporting member 29a. The second supporting member 29b is connected to the first supporting member 29a and may move together with the first supporting member 29a. A rotary driving device (not shown) is connected to the first supporting member 29a, and configured to drive the first supporting member 29a and the second supporting member 29b to rotate together. Similar to the above description, the cleaning device 6 is detachably mounted on the second supporting member 29b of the supporting device 29, and maintains in contact with and moving (for example, rising or falling vertically, or rotating) together with the second supporting member 29b at least during the cleaning process. After the cleaning process is finished, the cleaning device 6 can also be easily detached from the second supporting member 29b and moved out of the reaction chamber 1. For realizing the detachable connecting structure between the cleaning device 6 and the second supporting member 29b, as an embodiment, a snap-fit structure (not shown) may be provided respectively and correspondingly on a connecting surface S2 (S2 is also a supporting surface for the supporting device 29) of each of the cleaning device 6 and the second supporting member 29b, such that the cleaning device 6 is detachably placed on the second supporting member 29b directly and may move together with the second supporting member 29b, for example, rotating. Preferably, the second supporting member 29b is an annular supporting member and may be made of quartz or stainless steel.

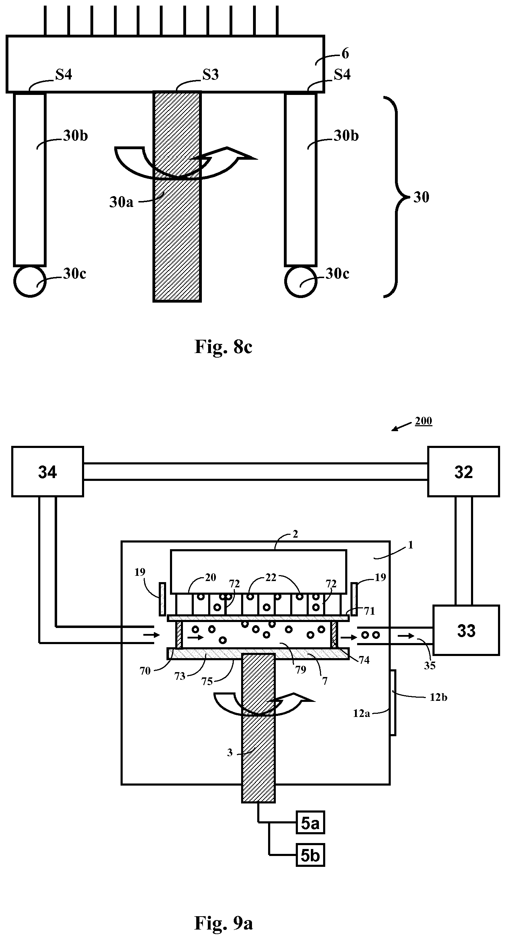

Fig. 8c is a schematic view illustrating the assembly of the above cleaning device and another embodiment of the supporting device. A supporting device 30 as shown in Fig. 8c includes a first supporting member 30a and a second supporting member 30b, with a rotation wheel 30c being connected under the second supporting member 30b. The first supporting member 30a and the second supporting member 30b collectively support the cleaning device 6 and drive the cleaning device 6 to rotate. A rotary driving device (not shown) is connected to the first supporting member 30a, and configured to drive the first supporting member 30a, the cleaning device 6, the second supporting member 30b and the rotation wheel 30c to rotate together. Similar to the above description, the cleaning device 6 is detachably mounted on the first supporting member 30a and the second supporting member 30b of the supporting device 30, and maintains in contact with and moving (for example, rising or falling vertically, or rotating) together with the first supporting member 30a and the second supporting member 30b at least during the cleaning process. After the cleaning process is finished, the cleaning device 6 can also be easily detached from the first supporting member 30a and the second supporting member 30b and moved out of the reaction chamber 1. For realizing the detachable connecting structure between the cleaning device 6 and the supporting device 30, as an embodiment, a snap-fit structure (not shown) may be provided respectively and correspondingly on a connecting surface S3 of each of the cleaning device 6 and the first supporting member 30a, such that the cleaning device 6 is detachably placed on the first supporting member 30a directly and may maintain moving together with the first supporting member 30a, such as rotating. A snap-fit structure (not shown) may also be provided respectively and correspondingly on a connecting surface S4 of each of the cleaning device 6 and the second supporting member 30b, such that the cleaning device 6 is detachably placed on the second supporting member 30b directly and may maintain moving together with the second supporting member 30b, such as rotating. The connecting surfaces S3 and S4 form the supporting surface of the supporting device 30. Preferably, the first supporting member 30a is a supporting shaft, and is supported at a center position of the bottom surface of the cleaning device 6; and the second supporting member 29b is a supporting ring.

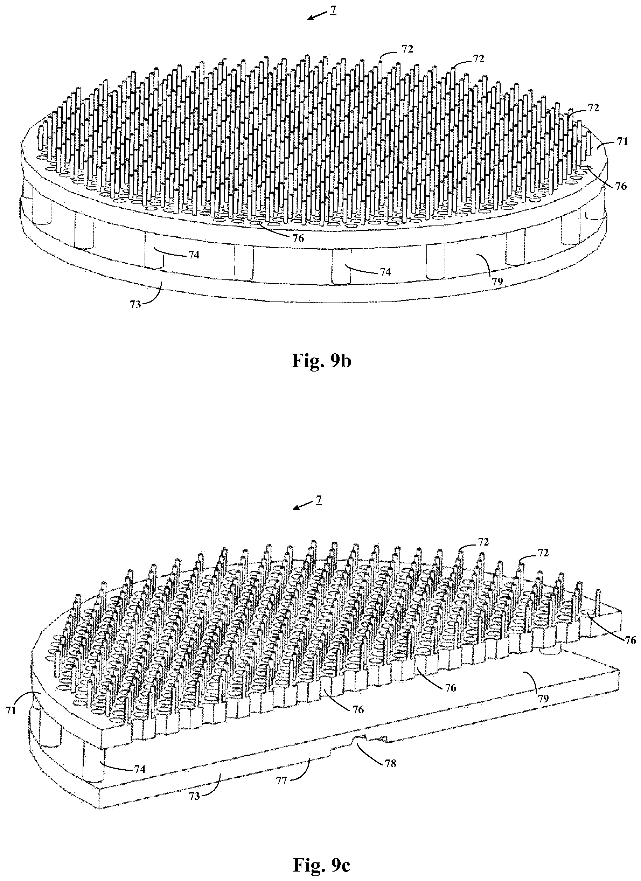

Fig. 9a is a schematic view illustrating another device for cleaning the gas conveying device according to the present application as well as the cleaning process. Figs. 9b and 9c are respectively a perspective schematic view and a cross-sectional schematic view of the cleaning device in Fig. 9a. The difference between a device 200 as shown in Fig. 9a and the device 100 as shown in Fig. 2b lies in different cleaning devices. Referring to Figs. 9b and 9c, a cleaning device 7 includes a first connecting plate 71, a second connecting plate 73, and a connecting structure (shown as a plurality of connecting columns) 74 connecting the first connecting plate 71 and the second connecting plate 73. The first connecting plate 71 and the second connecting plate 73 are spaced apart from each other by a distance so as to form a horizontal space or a hollow cavity 79. A plurality of scraping structures 72 are provided on the first connecting plate 71. The first connecting plate 71 is provided thereon with a plurality of passages 76 (shown as through holes) extending through upper and bottom surfaces of the first connecting plate 71. The bottom surface 77 of the second connecting plate 73 is provided with a concave portion 78 similar to the above concave portion in Fig. 3b, such that the second connecting plate 73 is detachably connected with the supporting device 3 located therebelow. A suction port 35 is provided between the first connecting plate 71 and the second connecting plate 73 such as to be in fluid communication with the space 79. During the process of cleaning the gas conveying device 2, the rotary driving device 5a drives the supporting device 3 and the cleaning device 7 to rotate together. The scraping structures 72 at least partially contact with the gas conveying surface 20 of the gas conveying device 2 and remove the adhered aggregates 22 adhered to the gas conveying surface 20. Due to the suction of the suction port 35, the removed adhered aggregates 22 may enter into the space 79 through the passages 76 and may be expelled to the outside of the reaction chamber 1 through the suction port 35 (in the direction indicated by the arrow as shown in Fig. 9a). Also, the suction port 35 is connected with the aggregate collecting device 33, the air exhaust pump or blower 34 and the like to form a suction gas flowing route.

It should be understood that, the passages 76 provided in the first connecting plate 71 and extending through upper and bottom surfaces of the plate may also be varied into any other passage structures through which may allow the adhered aggregates 22 and gases to pass, such as various hollow structures, or grooves, or a combination of grooves and holes. Further, the locations of grooves or holes may be varied according to the practical requirements, for example, elongate grooves, annular grooves or annular holes.

In Fig. 9a, during the process of cleaning the gas conveying device 2, for improving the cleaning efficiency, inert gases or other gases, such as H₂, may be blown into the reaction chamber 1 selectively via the gas conveying device 2 to blow the adhered aggregates 20 into the horizontal space or the hollow cavity 79. Further, optionally, a barrier device 19 may be provided adjacent to the peripheral of the plurality of scraping structures 72. The barrier device 19 is provided adjacent to the peripheral of the gas conveying device 2 inside the reaction chamber 1 and encircles the plurality of scraping structures 72, thereby forming a barrier device to prevent the adhered aggregates 22 removed from the gas conveying device 2 from escaping to the outside of the barrier device 19 along with the airflow. As an embodiment, the barrier device 19 may be provided such that it is movable up and down. During the film growth process, the barrier device 19 may be retracted to the peripheral of the gas conveying device 2, so as not to affect the film growth process; and during the cleaning process, the barrier device 19 may extend by a certain distance downwardly from the peripheral of the gas conveying device 2, so as to provide different degrees of barrier effect according to the requirements of the cleaning process. In addition, as another embodiment, the barrier device 19 may also be a part of the cleaning device 7 and is provided on a top surface of the first connecting plate 71 of the cleaning device 7 at the peripheral area of the plurality of scraping structures 72. As a preferred embodiment, the barrier device 19 is of an annular structure.

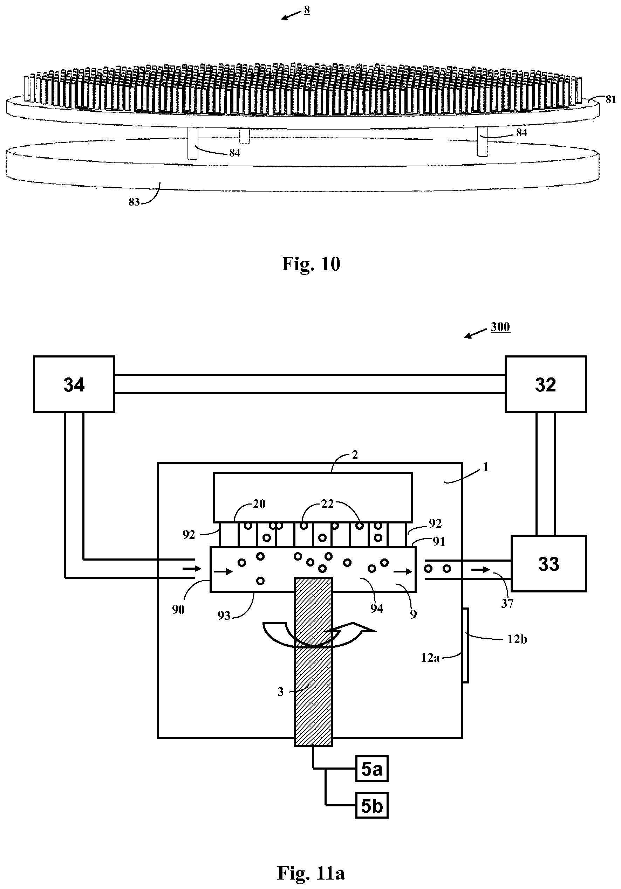

Fig. 10 shows a variation of the cleaning device as shown in Fig. 9b. The difference between a cleaning device 8 as shown in Fig. 10 and the cleaning device 7 in Fig. 9b lies in that, a plurality of connecting columns 84 of the cleaning device 8 as shown in Fig. 10 are provided at the area adjacent to the center between a first connecting plate 81 and a second connecting plate 83, while the plurality of connecting columns 74 of the cleaning device 7 as shown in Fig. 9b are provided at the area adjacent to the outer edge between the first connecting plate 71 and the second connecting plate 73.

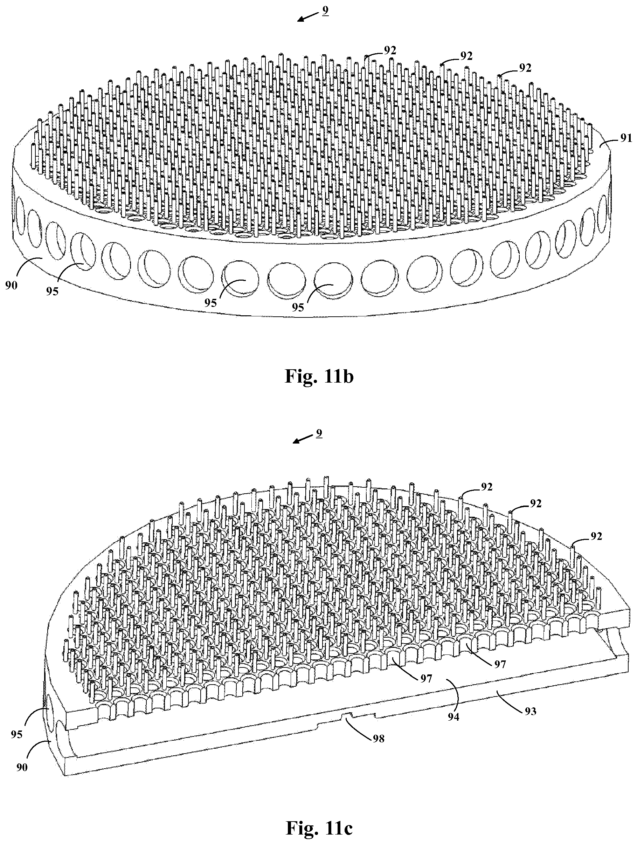

Fig. 11a is a schematic view illustrating another device for cleaning the gas conveying device according to the present application as well as the cleaning process. Figs. 11b and 11c are respectively a perspective schematic view and a cross-sectional schematic view of the cleaning device in Fig. 11a. The difference between a device 300 as shown in Fig. 11a and the device 100 as shown in Fig. 2b lies in different cleaning devices. Referring to Figs. 11b and 11c, a cleaning device 9 includes a first connecting plate 91, a second connecting plate 93, and a connecting structure (shown as a side wall) 90 connecting the two connecting plates. A plurality of gas passages (shown as through holes) 95 are provided in the side wall 90. A plurality of scraping structures 92 are distributed on the top surface of the first connecting plate 91. The first connecting plate 91 is provided thereon with gas passages (shown as through holes) 97 extending through the plate. The bottom surface of the second connecting plate 93 is provided with a concave portion 98 similar to that described above, such as to be detachably connected with the supporting device 3 located therebelow. A suction port 37 is provided between the first connecting plate 91 and the second connecting plate 93 such as to be in fluid communication with the space 94. During the process of cleaning the gas conveying device 2, the rotary driving device 5a drives the supporting device 3 and the cleaning device 9 to rotate together. The scraping structures 92 at least partially contact with the gas conveying surface 20 of the gas conveying device 2 and remove the adhered aggregates 22 adhered to the gas conveying surface. Due to the suction of the suction port 37, the removed adhered aggregates 22 may enter into the space 94 through the passages 97 and may again be expelled to the outside of the reaction chamber 1 through the plurality of gas passages 95 provided in the side wall 90 (in the direction indicated by the arrow as shown in Fig. 11a). Also, the suction port 37 is connected to the aggregate collecting device 33, the air exhaust pump or blower 34 and the like to form a gas flowing route.

It should be understood that, the above gas passages 95 and 97 may also be varied into other forms, such as various hollow structures, or grooves, or slots, or a combination of grooves and holes.

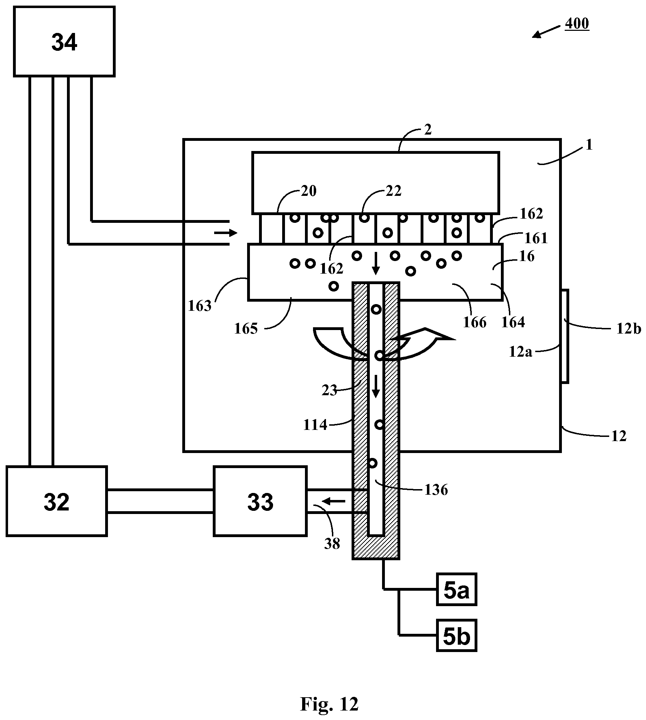

Fig. 12 is a schematic view illustrating another device for cleaning a gas conveying device according to the present application as well as the cleaning process. A cleaning device 16 in a device 400 includes a main body 164. The main body 164 includes a first connecting plate 161, a second connecting plate 165 and, a connecting structure (shown as a side wall) 163 connecting the two connecting plates. A cavity 166 is formed in the main body 164. The first connecting plate 161 of the cleaning device 16 is provided thereon with a plurality of scraping structures 162 and a plurality of through hole or passage structures (not shown) extending through upper and bottom surfaces of the first connecting plate 161. A supporting device 23 includes a rotatable shaft 114, and an air exhaust passage 136 is provided inside the rotatable shaft 114 along the axis and is in communication with the cavity 166 of the cleaning device 16. A suction port 38 is in communication with the air exhaust passages 136. The suction port 38 is connected to or in fluid communication with the aggregate collecting device 33 so as to collect the removed aggregates 22. During the process of cleaning the gas conveying device 2, the rotary driving device 5a drives the supporting device 23 and the cleaning device 16 to rotate together. The scraping structures 162 at least partially contact with the gas conveying surface 20 of the gas conveying device 2 and remove the adhered aggregates 22 adhered to the gas conveying surface. Due to the suction of the suction port 38, the removed adhered aggregates 22 may enter into the cavity 166 through the through holes or passage structures in the first connecting plate 161 and may again be expelled to the outside of the reaction chamber 1 through the air exhaust passage 136 (in the direction indicated by the arrow as shown in Fig. 12). Also, the suction port 38 is connected to the aggregate collecting device 33, the air exhaust pump or blower 34 and the like to form a gas flowing route.

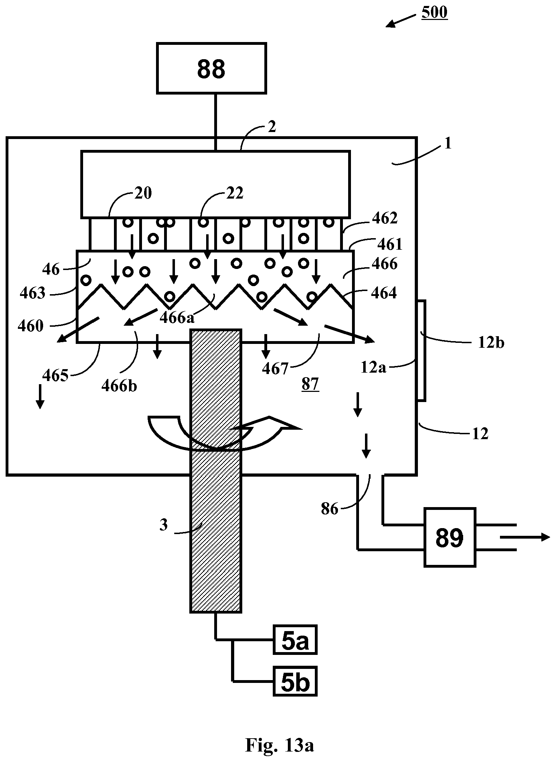

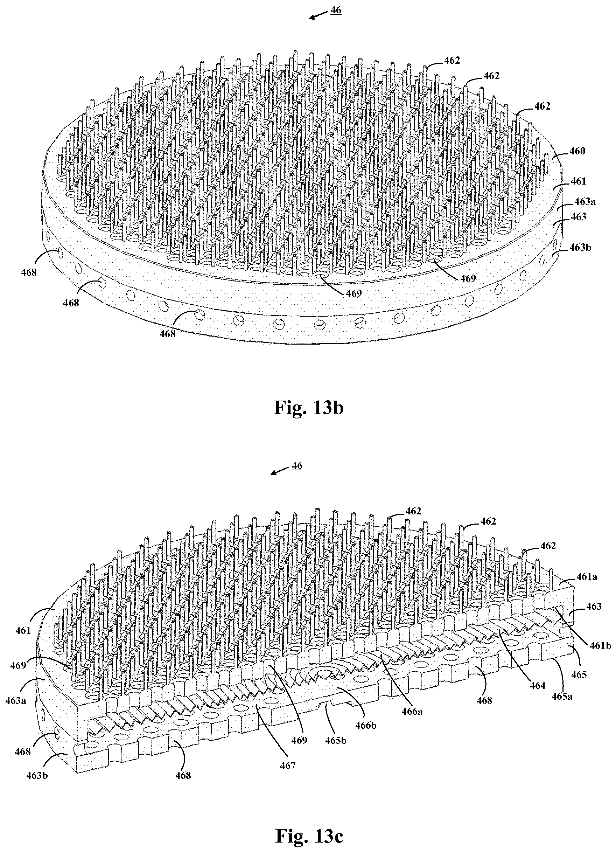

Fig. 13a is a schematic view illustrating another device for cleaning a gas conveying device according to the present application as well as the cleaning process. Figs. 13b and 13c are respectively a perspective schematic view and a cross-sectional schematic view of the cleaning device in Fig. 13a. A cleaning device 46 in a device 500 includes a main body 460. The main body 460 includes a first connecting plate 461, a second connecting plate 465, and a connecting structure (schematically shown as a side wall) 463 connecting the two connecting plates. The first connecting plate 461 and the second connecting plate 465 are arranged apart from each other by a distance, and a hollow cavity 467 is formed therebetween. The first connecting plate 461 includes an upper surface 461a and a bottom surface 461b (see Fig. 13c). At least a part of area of the upper surface 461a of the first connecting plate 461 is provided with a plurality of scraping structures 462, and the first connecting plate 461 is further provided thereon with a plurality of first passages (shown as through holes) 469 extending through upper and bottom surfaces of the first connecting plate 461. A plurality of gas passages 468 are provided in the second connecting plate 465 and/or the connecting structure 463. The plurality of gas passages 468 may be through holes, grooves, slots, or various hollow structures, and specifically, are schematically shown as through holes in the figures. The second connecting plate 465 includes a bottom surface 465a, on which a connecting portion 465b is provided. The connecting portion 465b is detachably mounted at the supporting end or on the supporting surface of the supporting device 3.

An aggregate filtering device 464 is further provided in the cavity 467 inside the main body 460. The aggregate filtering device 464, the first connecting plate 461 and a part of the connecting structure 463 define and form an aggregate collecting cavity 466a which is in fluid communication with the plurality of first passages 469 of the first connecting plate 461. The aggregate filtering device 464 is provided with a plurality of small aggregate filtering holes (not shown) through which the adhered aggregates 22 removed from the surface 20 of the gas conveying device 2 can be collected and saved in the aggregate collecting cavity 466a and filtered clean gas can be allowed to enter into an air exhaust cavity 466b located below the aggregate filtering device 464. The air exhaust cavity 466b as shown is defined and formed by the second connecting plate 465, a part of the connecting structure 463 and the aggregate filtering device 46. A plurality of gas passages 468 of the second connecting plate 465 enable the air exhaust cavity 466b to be in fluid communication with the air exhaust area 87 inside the reaction chamber 1. A suction port 86 is provided in the bottom portion or the side wall of the reaction chamber 1 such as to be in fluid communication with the inside of the reaction chamber 1, and is connected to an air exhaust device 89 (for example, an air exhaust pump or a blower).

As shown in Fig. 13a, the clean gas conveying device 2 may be selectively connected to a gas source 88 for feeding or blowing gas into the reaction chamber 1 during the cleaning process of the clean gas conveying device 2. During the cleaning process of the gas conveying device 2, the clean gas conveying device 2 blows gas downwards, and at the same time, the air exhaust device 89 is working. The rotary driving device 5a drives the supporting device 3 and the cleaning device 46 to rotate together. The scraping structures 462 at least partially contact with the gas conveying surface 20 of the gas conveying device 2 and remove the adhered aggregates 22 adhered to the gas conveying surface 20. Due to the suction of the air exhaust device 89 of the reaction chamber 1, the removed adhered aggregates 22 is sucked into the aggregate collecting cavity 466a through the plurality of first passages 469 of the first connecting plate 461 along a downward arrow as shown. Due to the filtration of the aggregate collecting device 464, the adhered aggregates 22 may be accumulated and collected inside the aggregate collecting cavity 466a, and the filtered clean gas may enter into the air exhaust cavity 466b again, enter into the area 87 inside the reaction chamber 1 through the gas passages 468, and finally be expelled to the outside of the reaction chamber 1 by the air exhaust device 89. During the process, the clean gas conveying device 2, the aggregate collecting cavity 466a, the air exhaust cavity 466b, the area 87, the suction port 86 and the air exhaust device 89 are all in fluid communication with each other and form a gas flowing route.

The above said aggregate collecting device 464 may be embodied in various forms. A preferred embodiment is a filtering screen with fine and close filtering holes. The aggregate collecting device 464 may be fixedly connected to the connecting structure 463 or the first connecting plate 461, or may be detachably mounted on the connecting structure 463 or the first connecting plate 461. After the cleaning process is performed for a period of time, the aggregate collecting device 464 may be demounted and replaced by a new aggregate collecting device 464 for the next cleaning process. For example, in the embodiment as shown in Figs. 13b and 13c, the connecting structure 463 includes a first part 463a and a second part 463b which are detachably connected, and the aggregate filtering device 464 is detachably connected to the first part 463a of the connecting structure 463.

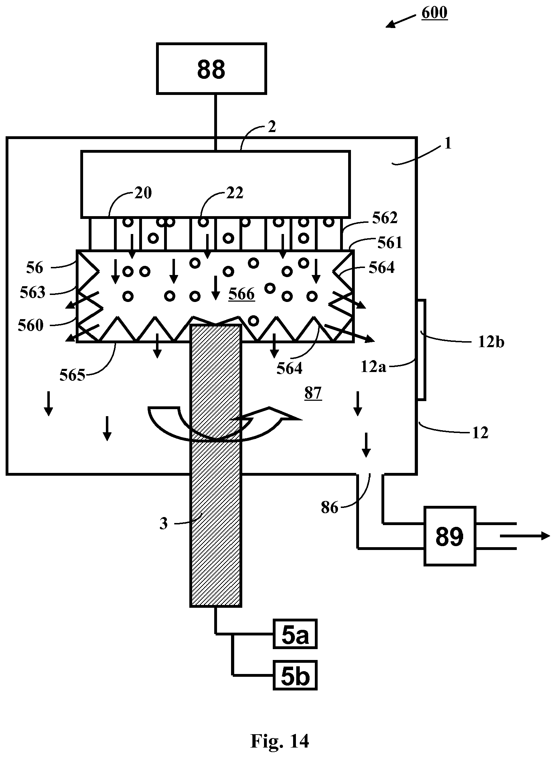

Fig. 14 is a schematic view illustrating another device for cleaning a gas conveying device according to the present application as well as the cleaning process. The embodiment as shown in Fig. 14 is a variation of the embodiment as shown in Fig. 13a, and the difference between the two embodiments lies in the variation of the cleaning device. A cleaning device 56 in a device 600 as shown in Fig. 14 includes a main body 560. The main body 560 includes a first connecting plate 561, a second connecting plate 565, and a connecting structure (schematically shown as a side wall) 563 connecting the two plates. These connecting plates and the connecting structure are connected with each other to form a hollow cavity. The first connecting plate 561 of the cleaning device 56 is provided with a plurality of scraping structures 562 and a plurality of first passages (not shown) extending through upper and bottom surfaces of the first connecting plate 561. An aggregate filtering device 564 is further provided inside the main body 560. The aggregate filtering device 564 is provided in the hollow cavity and is located between the first connecting plate 561 and the second connecting plate 565. Unlike the embodiment as shown in Fig. 13a, the aggregate filtering device 564 is provided adjacent to inner surfaces of both the second connecting plate 565 and the connecting structure 563. The first connecting plate 561 and the aggregate filtering device 564 define and form an aggregate collecting cavity 566 in fluid communication with the plurality of first passages of the first connecting plate 561. Also, a plurality of gas passages (not shown) are provided in the second connecting plate 565 and/or the connecting structure 563. The aggregate filtering device 564 is provided thereon with a plurality of small aggregate filtering holes (not shown). These filtering holes enable the removed adhered aggregates 22 to be collected and saved in the aggregate collecting cavity 566; and allow filtered clean gas to enter into an air exhaust area 87 of the reaction chamber 1 through the filtering hole in the aggregate collecting device 564 and the plurality of gas passages provided in the second connecting plate 565 and /or the connecting structure 563, and then is expelled through the suction port 86 and the air exhaust device 89. Also, the clean gas conveying device 2 may be selectively connected to a gas source 88 for feeding or blowing gas into the reaction chamber 1 during the process of cleaning the clean gas conveying device 2. During the process of cleaning the gas conveying device 2, the clean gas conveying device 2 blows gas downwards, and at the same time, the air exhaust device 89 is working. The rotary driving device 5a drives the supporting device 3 and the cleaning device 56 to rotate together. The scraping structures 562 at least partially contact with the gas conveying surface 20 of the gas conveying device 2 and remove the adhered aggregates 22 adhered to the gas conveying surface 20. Due to the suction of the air exhaust device 89 for the reaction chamber 1, the removed adhered aggregates 22 is sucked into the aggregate collecting cavity 566 through the first passages of the first connecting plate 561 along a downward arrow and/or an arrow towards both sides as shown. Due to the filtration of the aggregate collecting device 564, the adhered aggregates 22 may be accumulated and collected inside the aggregate collecting cavity 566; and the filtered gas may then enter into the area 87 inside the reaction chamber 1 through the plurality of gas passages of the second connecting plate 565 and/or the connecting structure 563, and finally is expelled to the outside of the reaction chamber 1 by the air exhaust device 89. During the process, the clean gas conveying device 2, the aggregate collecting cavity 566, the area 87 and the air exhaust device 89 are all in fluid communication with each other and form a gas flowing route.

Also, the above said aggregate collecting device 564 may be embodied in various forms. A preferred embodiment is a filtering screen with fine and close filtering holes. The aggregate collecting device 564 may be fixedly connected to the connecting structure 563 or the first connecting plate 561, or may be detachably mounted on the connecting structure 563 or the first connecting plate 561. After the cleaning process is performed for a period of time, the aggregate collecting device 564 may be demounted and replaced by a new aggregate collecting device 564 for the next cleaning process.

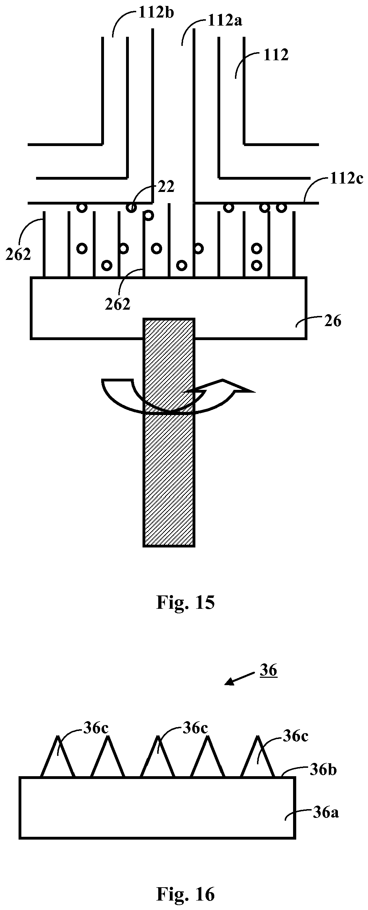

It should be understood that, the gas conveying device in the present application may be of any type. For example, the above gas conveying devices 2 as shown are all a gas distribution showerhead device having a generally flat gas conveying surface 20, and are provided therein with multiple small closely-distributed gas distribution holes. The gas conveying devices 2 in the present application may also be an injector-type gas dispersing device as shown in Fig. 15. Fig. 15 is a schematic view illustrating another process of cleaning a gas conveying device according to the present application. A gas conveying device 112 as shown includes a plurality of gas injection passages 112a and 112b for transporting various reaction gases. The gas conveying device 112 further includes a gas conveying surface 112c. A cleaning device 26 includes a plurality of scraping components 262 for cleaning the adhered aggregates 22 on the gas conveying surface 112b. It should be understood that, the gas conveying device in the present application may be a combination of the gas distribution showerhead device and the injector-type gas dispersing device.

Fig. 16 shows another embodiment of the cleaning device according to the present application. A cleaning device 36 includes a main body 36a including a first connecting plate 36b. A plurality of scraping structures 36c are provided on the first connecting plate 36b. The plurality of scraping structures 36c are of ridged scraping blade structures. Optionally, the main body 36a may also be provided as the various main bodies of the cleaning device described above in the Figs. 3a to 15. Of course, the scraping structures on the first connecting plate 36b may also include both the ridged scraping blade structures and the bristle structures.

As described above, the cleaning device according to the present application may be embodied in various forms. In a preferred embodiment, the cleaning device is a dummy of a substrate carrier. The connecting portion between the cleaning device and the supporting device has the same structure and size as those of the connecting portion between the substrate carrier and the supporting device. Taking the cleaning device 6 in Fig. 2a for instance, the cleaning device 6 has the same substantially cylindrical shape, the same diameter, the same connecting structure for connecting the supporting device 3 as those of the substrate carrier in Fig. 1. In this way, after the film growth process is performed for a period of time, the film growth process is stopped, and without opening the chamber cover of the reaction chamber 1, the conveying robot R of the mechanical conveying device T may directly detach the substrate carrier 8 from the supporting device 3, and move the substrate carrier 8 to the outside of the reaction chamber 1, and then mount the cleaning device 6 having a similar structure as the substrate carrier 8 to perform the process of cleaning the gas conveying device 2. Unlike the prior art, the complete cleaning process does not need to open the reaction chamber cover, and does not need the manual operation. Thus, the complete cleaning process may be automatically accomplished by a device or a system. Since the reaction chamber cover of the reaction chamber remains in a closed state, there is no need to wait for performing the cleaning process until the temperature in the reaction chamber 1 is decreased to a certain temperature.

The mechanical conveying device T as shown is only illustrative, and may be a substrate transfer chamber connected to the reaction chamber 1. The above conveying robot may be provided inside the substrate transfer chamber. Of course, the mechanical conveying device T may also be configured in other forms, for example, a single robot conveying device.

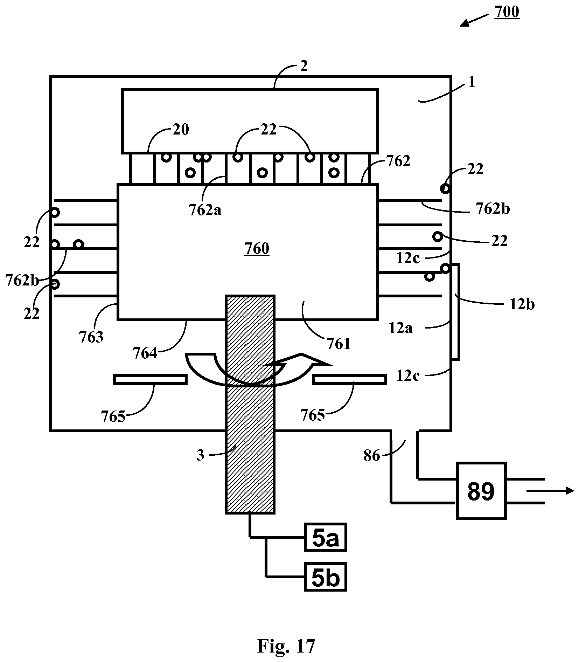

It should be understood that, in the embodiments and implementations as shown in the above Figs. 11a to 15 and the following Fig. 17, a barrier device 19 as shown in Fig. 9a may be selectively provided so as to improve the cleaning efficiency.

Based on the above essence and spirit of the present application, the present application further provides a method for cleaning a gas conveying device 2 in a film growth reaction chamber 1, wherein the gas conveying device 2 includes a gas conveying surface 20 for releasing reaction gases into the reaction chamber 1, and a supporting device 3 is provided in the reaction chamber 1. The method includes:
a) providing a cleaning device 6 and detachably mounting the cleaning device 6 on the supporting device 3, wherein the cleaning device 6 includes a surface 61 facing the gas conveying surface 20 and provided with a plurality of scraping structures 62 thereon; and
b) adjusting position of the cleaning device 6 (for example, the height position or the horizontal position), such that the scraping structures 62 may at least partially contact with the gas conveying surface 20 of the gas conveying device 2; and rotating the cleaning device 6, such that the scraping structures 62 contact with the gas conveying surface 20 and remove the adhered aggregates adhered to the gas conveying surface 20.

Optionally, the above method further includes: providing a rotary driving device 5a connected to the supporting device 3; starting the rotary driving device 5a to drive the supporting device 3 and the cleaning device 6 to rotate together.

Optionally, the above step b) further includes: providing a suction port in fluid communication with the inside of the reaction chamber, wherein the suction port is connected to an air exhaust pump or a blower for suctioning the adhered aggregates into an aggregate collecting device or suctioning the adhered aggregates out of the reaction chamber.

The suction port may be provided in various locations as needed. For example, as shown in Fig. 2b, the suction port is provided in a side wall of the reaction chamber 1, and located in a horizontal space formed by the gas conveying surface 20 and the surface 61 of the cleaning device 6 and adjacent to the scraping structures 62 of the cleaning device 6. The suction port may also be provided in a bottom portion or a side wall of the reaction chamber as shown in Fig. 13a. When the suction port is provided in a bottom portion or a side wall of the reaction chamber, the air exhaust device 89 used in performing the film growth process in the reaction chamber 1 may be utilized directly, and the air exhaust device 34 as shown in Fig. 2b need not to be additionally provided.

Preferably, the above supporting device 3 also acts as a supporting device for loading the substrate carrier 8 inside the reaction chamber 1. The substrate carrier 8 in the reaction chamber 1 is configured to convey and support the substrate 8a. The substrate carrier 8 is detachably mounted on the supporting device 3 and contacts with the supporting device 3 at least during the film growth process performed in the reaction chamber 1. The substrate carrier 8 can be easily removed from the supporting device 3 so as to be conveyed for loading or unloading the substrate 8a.

Preferably, during the process of step b), inert gases or other gases (such as H₂) may be blown into the reaction chamber 1 via the gas conveying surface 20 of the gas conveying device 2 to blow the adhered aggregates 20 into a proper space.

Preferably, an aggregate collecting device in fluid communication with the suction port is provided inside the above cleaning device so as to collect the adhered aggregates. The specific implementation may refer to the cleaning device illustrated in Fig. 13a or 14.

Preferably, during the process of implementing the above methods, the reaction chamber cover of the reaction chamber remains in a closed state.

Based on the essence and spirit of the present application, there is further provided in the present application a method for film growth in a reaction chamber, wherein a supporting device having a supporting end or a supporting surface is provided in the reaction chamber. The method includes:
a) providing a substrate carrier on which one or more substrates is loaded;
b) moving the substrate carrier into the reaction chamber and detachably mounting the substrate carrier on the supporting end or the supporting surface of the supporting device;
c) releasing reaction gases into the reaction chamber through a gas conveying surface of a gas conveying device, and rotating the supporting device and the substrate carrier for the film growth on the substrate;
d) stopping step c), detaching the substrate carrier from the supporting end or the supporting surface of the supporting device and moving the substrate carrier out of the reaction chamber;
e) providing a cleaning device and moving the cleaning device into the reaction chamber, and detachably mounting the cleaning device on the supporting end or the supporting surface of the supporting device, wherein the cleaning device includes a surface facing the gas conveying surface and provided with a plurality of scraping structures;
f) adjusting position of the cleaning device such that the plurality of scraping structures may at least partially contact with the gas conveying surface;
g) rotating the supporting device and the cleaning device, such that the plurality of scraping structures at least partially contact with the gas conveying surface and remove the adhered aggregates adhered to the gas conveying surface; and
h) stopping step g), detaching the cleaning device from the supporting end or the supporting surface of the supporting device and moving the cleaning device out of the reaction chamber.

Preferably, the above step g) further includes the step of providing a suction port in fluid communication with the inside of the reaction chamber, wherein the suction port is connected to an air exhaust pump or a blower.

Preferably, the above method further includes the step of providing an aggregate collecting device in connection with the suction port, wherein the aggregate collecting device is configured to collect the adhered aggregates.

Preferably, an aggregate collecting device in fluid communication with the suction port is provided in the cleaning device to collect the adhered aggregates.

Preferably, during the process of implementing the above method, the reaction chamber cover of the reaction chamber remains in a closed state.

According to the essence and the spirit of the present application, the above device and method according to the present application may be further broadened and varied to provide a method and device for removing the adhered aggregates on the inner surface of the film growth reaction chamber. As shown in Fig. 17, Fig. 17 is a schematic view illustrating a device for removing adhered aggregates on the inner surface of the film growth reaction chamber and the removing process according to the present application. A device 700 includes a film growth reaction chamber 1. After the film growth process is performed for a period of time, some adhered aggregates 22 may be deposited or adhered onto the inner surface of the reaction chamber 1. The inner surface of the reaction chamber 1 refers to the outer surfaces of any components exposed in the film growth process environment inside the reaction chamber 1, including but not limited to, the gas conveying surface 20 of the gas conveying device 2, the inner side wall 12c of the reaction chamber 1, and an outer surface of a heating element 765 located below the substrate carrier, etc. A cleaning device 760 is generally similar to the above various embodiments, except that scraping structures are provided in broadened range and area. As an embodiment, the cleaning device 760 includes a main body 761 having several surfaces facing the inner surface of the reaction chamber 1. For example, as schematically shown, the main body 761 at least includes a first surface 762, a second surface 763 and a third surface 764. The first surface 762 is provided such as to face and be parallel to the gas conveying surface 20 of the gas conveying device 2, the second surface 763 faces the inner side wall 12c of the reaction chamber 1 and the third surface 764 faces the outer surface of the heating element 765. A plurality of scraping structures 762a and 762b are provided on the first surface 762 and the second surface 763. A plurality of scraping structures may also be provided on the third surface 764 according to the practical requirements. As the embodiments described above, the suction port 86 connected to the air exhaust device 89 such as an air exhaust pump or a blower is provided in the reaction chamber 1, and various aggregate collecting devices (not shown) in fluid communication with the suction port 86 may be further provided to collect the adhered aggregates. Similarly, the reaction chamber 1 further includes the supporting device 3 according to the above various embodiments. The cleaning device 760 is detachably mounted on the supporting device 3 and keeps moving together with the supporting device 3, for example, rising or falling and/or rotating.

When the device 700 is used to clean the adhered aggregates on the inner surface of the film growth reaction chamber 1, the method includes:
a) providing a cleaning device 760 into the reaction chamber 1 and detachably mounting the cleaning device 760 on the supporting device 3, wherein the cleaning device 760 includes one or more surfaces 762, 763 facing the inner surfaces 20, 12c of the reaction chamber 1, and the surfaces 762, 763 are provided with a plurality of scraping structures 762a, 762b thereon; and
b) adjusting position of the cleaning device 760, such that the scraping structures 762a, 762b may at least partially contact with the inner surfaces 20, 12c of the reaction chamber, and rotating the cleaning device 760, such that the scraping structures 762a, 762b contact with the inner surfaces 20, 12c of the reaction chamber and remove the adhered aggregates 22 adhered to the inner surfaces 20, 12c of the reaction chamber.

Optionally, the above method further includes the step of adjusting a vertical height of the cleaning device 760 in the reaction chamber 1 while rotating the cleaning device 760, such that the scraping structures 762b of the cleaning device 760 may move up and down along the side wall 12c and contact with the side wall 12c so as to remove all the adhered aggregates on the side wall 12c.

Optionally, the above method further includes: providing a suction port 86 in fluid communication with the inside of the reaction chamber, wherein the suction port 86 is connected to an air exhaust pump or a blower 89; and operating the air exhaust pump or the blower 89 to perform a suction function.

Optionally, the above method further includes the step of providing an aggregate collecting device (not shown) in fluid communication with the suction port 86, wherein the aggregate collecting device is configured to collect the adhered aggregates.

Optionally, an aggregate collecting device (not shown) in fluid communication with the suction port 86 is provided inside the cleaning device 76, and the aggregate collecting device is configured to collect the adhered aggregates..

The reaction chamber 1 in the above various devices may be various types of reaction chamber, including but not limited to, a vertical reaction chamber, a horizontal reaction chamber, a planetary reaction chamber, a vertical spray-type reaction chamber and a high-speed rotary disc reaction chamber.

The device and method provided by the present application are applicable to any film growth processes, including but not limited to, an MOCVD process and an HVPE process for growing epitaxial layer on the substrate, e.g., for group III and group V element compound film growth.

It should be understood that, the "reaction gas" mentioned in the present application is not limited to one kind of gas, but also includes a mixed gas of various gases.

Compared with the prior art, the reaction device and the cleaning method provided by the present application have some advantages. For example, the whole process for cleaning or removing the adhered aggregates on the surface of the gas conveying device or the inner surface of the film growth reaction chamber may be performed without the need of opening the reaction chamber cover, and thus it is an in-situ cleaning method. The whole process may be realized automatically. Furthermore, the cleaning method is simple, convenient, and may ensure the quality and consistency of cleaning process so as to avoid having adverse effects on the subsequent film growth. In general, the producer's cost is greatly reduced and the effective processing uptime of the whole film growth device is greatly improved.

The various embodiments of the present application are described in detail hereinabove. It should be noted that, the above embodiments are only illustrative, and are not limiting the present application. In addition, any reference number in the claims should not be construed as a limitation to the claims. The term "include" does not exclude other devices or steps not listed in the claims or the specification; and the terms "first" and "second" and the like are only used to indicate the name, and do not indicate any specific order.

## Claims

1. A method for cleaning a gas conveying device (2) in a film growth reaction chamber (1), wherein the gas conveying device comprises a gas conveying surface (20) for releasing reaction gases into the reaction chamber, and a supporting device (3) is provided in the reaction chamber, the method comprising:
a) unloading a substrate carrier (8) after a film growth process is finished, wherein the substrate carrier is located in the reaction chamber and is detachably mounted on the supporting device (3), and wherein in the step of unloading the substrate carrier, the substrate carrier is detached from the supporting device (3) and is moved out of the reaction chamber;
b) providing a cleaning device (6) and moving the cleaning device into the reaction chamber, and detachably mounting the cleaning device on the supporting device (3), wherein the cleaning device comprises a surface (61) facing the gas conveying surface (20) and provided with a plurality of scraping structures (62) thereon; and
c) adjusting position of the cleaning device (6) such that the scraping structures (62) at least partially contact with the gas conveying surface (20) of the gas conveying device (2), and rotating the cleaning device (6), such that the scraping structures (62) contact with the gas conveying surface (20) and remove aggregates adhered to the gas conveying surface.

2. The method according to claim 1, further comprising: providing a rotary driving device connected to the supporting device, and starting the rotary driving device to drive the supporting device and the cleaning device to rotate together.

3. The method according to claim 1, further comprising: providing a suction port in fluid communication with the inside of the reaction chamber, wherein the suction port is connected to an air exhaust pump or a blower; and operating the air exhaust pump or the blower to perform a suction function.

4. The method according to claim 1, wherein the supporting device also acts as a supporting device for carrying a substrate carrier in the reaction chamber.

5. The method according to claim 1, wherein a substrate carrier is further provided in the reaction chamber to convey and support substrates, the substrate carrier is detachably mounted on the supporting device and contacts with the supporting device at least during the film growth process performed in the reaction chamber, and the substrate carrier can be easily removed from the supporting device so as to be conveyed for loading or unloading the substrate.

6. The method according to claim 5, wherein a connecting portion between the cleaning device and the supporting device has the same structure and size as those of the connecting portion between the substrate carrier and the supporting device.

7. A method for film growth in a reaction chamber, wherein a supporting device having a supporting end or a supporting surface is provided in the reaction chamber, the method comprises the steps a), b) and c) according to claim 1 and the method further comprises steps a'), b'), and c') performed before the steps a), b) and c) according to claim 1:
a') providing a substrate carrier on which one or more substrates to be processed is loaded;
b') moving the substrate carrier into the reaction chamber and detachably mounting the substrate carrier on the supporting end or the supporting surface of the supporting device;
c') feeding reaction gases into the reaction chamber by a gas conveying device, and rotating the supporting device and the substrate carrier for film growth on the substrate;
wherein the method further comprises a step d') performed after the steps a), b) and c) according to claim 1:
d') stopping rotating the supporting device and cleaning device, and detaching the cleaning device from the supporting end or the supporting surface of the supporting device and moving the cleaning device out of the reaction chamber.

8. The method according to claim 7, wherein step g) further comprises: providing a suction port in fluid communication with the inside of the reaction chamber, wherein the suction port is connected to an air exhaust pump or a blower, and operating the air exhaust pump or the blower to perform a suction function.

9. The method according to claim 7, wherein a connecting portion between the cleaning device and the supporting device has the same structure and size as those of the connecting portion between the substrate carrier and the supporting device.

10. The method according to claim 7, wherein step g) comprises: providing a rotary driving device connected to the supporting device and starting the rotary driving device to drive the supporting device and the cleaning device to rotate together.

11. A reaction device for film growth on a substrate, comprising:
a reaction chamber (1);
a gas conveying device (2) provided in the reaction chamber (1) and comprising a gas conveying surface (20) for releasing reaction gases into the reaction chamber to form a compound film on the substrate (8a);
a supporting device (3) provided in the reaction chamber (1);
a substrate carrier (8) configured to be mounted on the supporting device (3), wherein the substrate carrier (8) is configured to support and load the substrate (8a) into the reaction chamber before a film growth process, and the substrate carrier (8) is configured to be removed from the supporting device (3) so as to be conveyed out of the reaction chamber before a cleaning process;
a cleaning device (6) configured to be detachably mounted on the supporting device (3) during the cleaning process, wherein the cleaning device (6) is configured to be removed from the supporting device (3) and moved out of the reaction chamber, and the cleaning device comprises a surface (61) facing the gas conveying surface (20) and provided with a plurality of scraping structures (62); and
a rotary driving device (5a) configured to selectively drive the plurality of scraping structures (62) on the cleaning device (6) to rotate;
wherein the cleaning device (6) is located in the reaction chamber at a position where at least part of the plurality of scraping structures (62) contact with the gas conveying surface (20) and remove aggregates adhered on the gas conveying surface.

12. The reaction device according to claim 11, further comprising a suction port (31) in fluid communication with the inside of the reaction chamber, wherein the suction port (31) is connected to an air exhaust pump or a blower (34).

13. The reaction device according to claim 11, wherein a connecting portion between the cleaning device (6) and the supporting device (3) has the same structure and size as those of the connecting portion between the substrate carrier (8) and the supporting device (3).

14. The reaction device according to claim 11, wherein the cleaning device (6) further comprises a barrier device (19) provided in the peripheral of the plurality of scraping structures (62) and encircling the plurality of scraping structures.

15. The reaction device according to claim 11, wherein the cleaning device (6) further comprises a second surface (63) facing an inner side wall of the reaction chamber, a plurality of scraping structures (62) are provided on the second surface (63).

## Patentansprüche

1. Verfahren zum Reinigen einen Gasfördervorrichtung (2) in einer Filmzüchtungs-Reaktionskammer (1), wobei die Gasfördervorrichtung eine Gasförderfläche (20) zum Freisetzen von Reaktionsgasen in die Reaktionskammer aufweist und eine Halterungsvorrichtung (3) in der Reaktionskammer vorgesehen ist, wobei das Verfahren umfasst:
a) Entladen eines Substratträgers (8) nach Beendigung eines Filmzüchtungsvorgangs, wobei sich der Substratträger in der Reaktionskammer befindet und an der Halterungsvorrichtung (3) abnehmbar angebracht ist, und wobei bei dem Schritt des Entladens des Substratträgers dieser von der Halterungsvorrichtung (3) abgenommen und aus der Reaktionskammer herausbewegt wird;
b) Bereitstellen einer Reinigungsvorrichtung (6) und Bewegen der Reinigungsvorrichtung in die Reaktionskammer, und abnehmbares Anbringen der Reinigungsvorrichtung an der Halterungsvorrichtung (3), wobei die Reinigungsvorrichtung eine Oberfläche (61) aufweist, die der Gasförderfläche (20) zugewandt ist und mit mehreren darauf befindlichen Schabestrukturen (62) versehen ist; und
c) Einstellen der Position der Reinigungsvorrichtung (6) derart, dass die Schabestrukturen (62) zumindest einen teilweisen Kontakt mit der Gasförderfläche (20) der Gasfördervorrichtung (2) haben, und Drehen der Reinigungsvorrichtung (6), derart, dass die Schabestrukturen (62) in Kontakt mit der Gasförderfläche (20) sind und an der Gasförderfläche anhaftende Ablagerungen entfernen.

2. Verfahren nach Anspruch 1, darüber hinaus umfassend:
Bereitstellen einen Drehantriebsvorrichtung, die mit der Halterungsvorrichtung verbunden ist, und Starten der Drehantriebsvorrichtung, um die Halterungsvorrichtung und die Reinigungsvorrichtung zusammen in Drehung zu versetzen.

3. Verfahren nach Anspruch 1, darüber hinaus umfassend:
Bereitstellen eines Ansaugkanals in Fluidverbindung mit dem Innenraum der Reaktionskammer, wobei der Ansaugkanal an eine Luftabsaugpumpe oder ein Gebläse angeschlossen ist; und
Betreiben der Luftabsaugpumpe oder des Gebläses zum Ausführen einer Saugfunktion.

4. Verfahren nach Anspruch 1, wobei die Halterungsvorrichtung auch als Halterungsvorrichtung zum Tragen eines Substratträgers in der Reaktionskammer fungiert.

5. Verfahren nach Anspruch 1, wobei ein Substratträger darüber hinaus in der Reaktionskammer vorgesehen ist, um Substrate zu befördern und zu tragen, wobei der Substratträger abnehmbar an der Halterungsvorrichtung angebracht ist und mit der Halterungsvorrichtung zumindest während des Filmzüchtungsvorgangs Kontakt hat, der in der Reaktionskammer abläuft, und der Substratträger leicht von der Halterungsvorrichtung abgenommen werden kann, um so zum Beladen oder Entladen des Substrats befördert zu werden.

6. Verfahren nach Anspruch 5, wobei ein Verbindungsabschnitt zwischen der Reinigungsvorrichtung und der Halterungsvorrichtung denselben Aufbau und dieselbe Größe hat wie ein Verbindungsabschnitt zwischen dem Substratträger und der Halterungsvorrichtung.

7. Verfahren zur Filmzüchtung in einer Reaktionskammer, wobei eine Halterungsvorrichtung, die ein Abstützende oder eine Stützfläche aufweist, in der Reaktionskammer vorgesehen ist, wobei das Verfahren die Schritte a), b) und c) nach Anspruch 1 und darüber hinaus die Schritte a'), b') und c') umfasst, die vor den Schritten a), b) und c) nach Anspruch 1 ausgeführt werden:
a') Bereitstellen eines Substratträgers, der mit einem oder mehreren zu bearbeitenden Substraten beladen wird;
b') Bewegen des Substratträgers in die Reaktionskammer und abnehmbares Anbringen des Substratträgers am Abstützende oder an der Stützfläche der Halterungsvorrichtung;
c') Einleiten von Reaktionsgasen in die Reaktionskammer durch eine Gasfördervorrichtung, und Drehen der Halterungsvorrichtung und des Substratträgers zur Filmzüchtung auf dem Substrat;
wobei das Verfahren des Weiteren einen Schritt d') aufweist, der nach den Schritten a), b) und c) nach Anspruch 1 ausgeführt wird:
d') Anhalten der Drehung der Halterungsvorrichtung und Reinigungsvorrichtung, und Abnehmen der Reinigungsvorrichtung vom Abstützende oder der Stützfläche der Halterungsvorrichtung und Herausbewegen der Reinigungsvorrichtung aus der Reaktionskammer.

8. Verfahren nach Anspruch 7, wobei Schritt g) darüber hinaus umfasst: Bereitstellen eines Ansaugkanals in Fluidverbindung mit dem Innenraum der Reaktionskammer, wobei der Ansaugkanal an eine Luftabsaugpumpe oder ein Gebläse angeschlossen ist, und Betreiben der Luftabsaugpumpe oder des Gebläses zum Ausführen einer Saugfunktion.

9. Verfahren nach Anspruch 7, wobei ein Verbindungsabschnitt zwischen der Reinigungsvorrichtung und der Halterungsvorrichtung denselben Aufbau und dieselbe Größe hat wie ein Verbindungsabschnitt zwischen dem Substratträger und der Halterungsvorrichtung.

10. Verfahren nach Anspruch 7, wobei Schritt g) umfasst: Bereitstellen einer Drehantriebsvorrichtung, die mit der Halterungsvorrichtung verbunden ist, und Starten der Drehantriebsvorrichtung, um die Halterungsvorrichtung und die Reinigungsvorrichtung zusammen in Drehung zu versetzen.

11. Reaktionsvorrichtung zur Filmzüchtung auf einem Substrat, aufweisend:
eine Reaktionskammer (1);
eine Gasfördervorrichtung (2), die in der Reaktionskammer (1) vorgesehen ist und eine Gasförderfläche (20) zum Freisetzen von Reaktionsgasen in die Reaktionskammer aufweist, um einen Verbundfilm auf dem Substrat (8a) zu bilden;
eine Halterungsvorrichtung (3), die in der Reaktionskammer (1) vorgesehen ist;
einen Substratträger (8), der dazu ausgelegt ist, an der Halterungsvorrichtung (3) angebracht zu werden, wobei der Substratträger (8) dazu ausgelegt ist, das Substrat (8a) zu haltern und vor einem Filmzüchtungsvorgang in die Reaktionskammer einzubringen, und der Substratträger (8) dazu ausgelegt ist, von der Halterungsvorrichtung (3) entfernt zu werden, um vor einem Reinigungsvorgang aus der Reaktionskammer herausbefördert zu werden;
eine Reinigungsvorrichtung (6), die dazu ausgelegt ist, während des Reinigungsvorgangs abnehmbar an der Halterungsvorrichtung (3) angebracht zu sein, wobei die Reinigungsvorrichtung (6) dazu ausgelegt ist, von der Halterungsvorrichtung (3) entfernt und aus der Reaktionskammer herausbewegt zu werden, und die Reinigungsvorrichtung eine Oberfläche (61) aufweist, die der Gasförderfläche (20) zugewandt ist und mit mehreren Schabestrukturen (62) versehen ist; und
eine Drehantriebsvorrichtung (5a), die dazu ausgelegt ist, die mehreren Schabestrukturen (62) an der Reinigungsvorrichtung (6) wählbar in Drehung zu versetzen;
wobei sich die Reinigungsvorrichtung (6) in der Reaktionskammer an einer Position befindet, an der die mehreren Schabestrukturen (62) zumindest zum Teil in Kontakt mit der Gasförderfläche (20) sind und an der Gasförderfläche anhaftende Ablagerungen entfernen.

12. Reaktionsvorrichtung nach Anspruch 11, darüber hinaus mit einem Ansaugkanal (31) in Fluidverbindung mit dem Innenraum der Reaktionskammer, wobei der Ansaugkanal (31) an eine Luftabsaugpumpe oder ein Gebläse (34) angeschlossen ist.

13. Reaktionsvorrichtung nach Anspruch 11, wobei ein Verbindungsabschnitt zwischen der Reinigungsvorrichtung (6) und der Halterungsvorrichtung (3) denselben Aufbau und dieselbe Größe hat wie ein Verbindungsabschnitt zwischen dem Substratträger (8) und der Halterungsvorrichtung (3).

14. Reaktionsvorrichtung nach Anspruch 11, wobei die Reinigungsvorrichtung (6) darüber hinaus eine Absperrvorrichtung (19) aufweist, die im Umfangsbereich der mehreren Schabestrukturen (62) vorgesehen ist und die mehreren Schabestrukturen umschließt.

15. Reaktionsvorrichtung nach Anspruch 11, wobei die Reinigungsvorrichtung (6) darüber hinaus eine zweite Oberfläche (63) aufweist, die einer Innenseitenwand der Reaktionskammer zugewandt ist, wobei mehrere Schabestrukturen (62) auf der zweiten Oberfläche (63) vorgesehen sind.

## Revendications

1. Procédé de nettoyage d'un dispositif de transport de gaz (2) dans une chambre de réaction pour croissance de film (1), le dispositif de transport de gaz comprenant une surface de transport de gaz (20) destinée à libérer des gaz de réaction dans la chambre de réaction, et la chambre de réaction étant munie d'un dispositif de support (3), ledit procédé comprenant :
a) le déchargement d'un support de substrat (8) à la fin d'un processus de croissance de film, le support de substrat étant disposé dans la chambre de réaction et monté de manière amovible sur le dispositif de support (3),
et à l'étape de déchargement du support de substrat, ledit support de substrat étant détaché du dispositif de support (3) et ressorti de la chambre de réaction ;
b) la fourniture d'un dispositif de nettoyage (6) et le déplacement du dispositif de nettoyage pour l'amener dans la chambre de réaction, et le montage de manière amovible du dispositif de nettoyage sur le dispositif de support (3), le dispositif de nettoyage comprenant une surface (61) en face de la surface de transport de gaz (20) et munie d'une pluralité d'ensembles racleurs (62) dessus ; et
c) l'ajustement de la position du dispositif de nettoyage (6) de telle sorte que les ensembles racleurs (62) entrent au moins partiellement en contact avec la surface de transport de gaz (20) du dispositif de transport de gaz (2), et la rotation du dispositif de nettoyage (6) de telle sorte que les ensembles racleurs (62) entrent en contact avec la surface de transport de gaz (20) et enlèvent les agrégats adhérant sur la surface de transport de gaz.

2. Procédé selon la revendication 1, comprenant en outre : fourniture d'un dispositif d'entraînement rotatif relié au dispositif de support, et démarrage du dispositif d'entraînement rotatif afin d'entraîner le dispositif de support et du dispositif de nettoyage afin qu'ils tournent ensemble.

3. Procédé selon la revendication 1, comprenant en outre : la fourniture d'un orifice d'aspiration en communication fluidique avec l'intérieur de la chambre de réaction, ledit orifice d'aspiration étant relié à une pompe d'évacuation d'air ou à un ventilateur ; et l'actionnement de la pompe d'évacuation d'air ou du ventilateur pour mettre en oeuvre une fonction d'aspiration.

4. Procédé selon la revendication 1, le dispositif de support servant aussi de dispositif de support pour porter un support de substrat dans la chambre de réaction.

5. Procédé selon la revendication 1, la chambre de réaction étant en outre munie d'un support de substrat pour transporter et supporter des substrats, ledit support de substrat étant monté de manière amovible sur le dispositif de support et entrant en contact avec le dispositif de support au moins pendant le processus de croissance de film mis en oeuvre dans la chambre de réaction, et le support de substrat pouvant être facilement retiré du dispositif de support de telle sorte à être transporté pour le chargement ou le déchargement du substrat.

6. Procédé selon la revendication 5, une portion de liaison entre le dispositif de nettoyage et le dispositif de support ayant les mêmes structure et taille que la portion de liaison entre le support de substrat et le dispositif de support.

7. Procédé de croissance de film dans une chambre de réaction, la chambre de réaction étant munie d'un dispositif de support présentant une extrémité de support ou une surface de support, ledit procédé comprenant les étapes a), b) et c) selon la revendication 1 et ledit procédé comprenant en outre les étapes a'), b') et c') mises en oeuvre avant les étapes a), b), et c) selon la revendication 1 :
a') la fourniture d'un support de substrat sur lequel est/ sont chargé(s) un ou plusieurs substrats à traiter ;
b') le déplacement du support de substrat pour l'amener dans la chambre de réaction et le montage de manière amovible dudit support de substrat sur l'extrémité ou la surface de support du dispositif de support ;
c') l'alimentation de la chambre de réaction en gaz de réaction par un dispositif de transport de gaz, et la rotation du dispositif de support et du support de substrat pour la croissance de film sur le substrat ;
le procédé comprenant en outre une étape d') mise en oeuvre après les étapes a), b), et c) selon la revendication 1 :
d') l'arrêt de la rotation du dispositif de support et du dispositif de nettoyage, et le détachement du dispositif de nettoyage de l'extrémité de support ou de la surface de support du dispositif de support, et le déplacement du dispositif de nettoyage pour le faire ressortir de la chambre de réaction.

8. Procédé selon la revendication 7, l'étape g) comprenant en outre : la fourniture d'un orifice d'aspiration en communication fluidique avec l'intérieur de la chambre de réaction, l'orifice d'aspiration étant relié à une pompe d'évacuation d'air ou à un ventilateur, et l'actionnement de la pompe d'évacuation d'air ou du ventilateur pour mettre en oeuvre une fonction d'aspiration.

9. Procédé selon la revendication 7, une portion de liaison entre le dispositif de nettoyage et le dispositif de support ayant les mêmes structure et taille que la portion de liaison entre le support de substrat et le dispositif de support.

10. Procédé selon la revendication 7, l'étape g) comprenant :
la fourniture d'un dispositif d'entraînement rotatif relié au dispositif de support, et le démarrage dudit dispositif d'entraînement rotatif destiné à entraîner le dispositif de support et du dispositif de nettoyage afin qu'ils tournent ensemble.

11. Dispositif de réaction pour croissance de film sur un substrat, comprenant :
- une chambre de réaction (1) ;
- un dispositif de transport de gaz (2) dont est munie la chambre de réaction (1) et qui comprend une surface de transport de gaz (20) destinée à libérer des gaz de réaction dans la chambre de réaction afin de former un film de composé sur le substrat (8a) ;
- un dispositif de support (3) dont est munie la chambre de réaction (1) ;
- un support de substrat (8) conçu pour être monté sur le dispositif de support (3), ledit support de substrat (8) étant conçu pour supporter et charger le substrat (8a) dans la chambre de réaction avant un processus de croissance de film, et ledit support de substrat (8) étant conçu pour être retiré du dispositif de support (3) de telle sorte à être transporté en dehors de la chambre de réaction avant un processus de nettoyage ;
- un dispositif de nettoyage (6) conçu pour être monté de manière amovible sur le dispositif de support (3) pendant le processus de nettoyage, ledit dispositif de nettoyage (6) étant conçu pour être retiré du dispositif de support (3) et ressorti de la chambre de réaction, et ledit dispositif de nettoyage comprenant une surface (61) en face de la surface de transport de gaz (20) et munie d'une pluralité d'ensembles racleurs (62) ; et un dispositif d'entraînement rotatif (5a) conçu pour entraîner en rotation de manière sélective la pluralité d'ensembles racleurs (62) sur le dispositif de nettoyage (6) ;
le dispositif de nettoyage (6) étant disposé dans la chambre de réaction dans une position à laquelle au moins une partie de la pluralité d'ensembles racleurs (62) entre en contact avec la surface de transport de gaz (20) et enlève les agrégats adhérant à la surface de transport de gaz.

12. Dispositif de réaction selon la revendication 11, comprenant en outre un orifice d'aspiration (31) en communication fluidique avec l'intérieur de la chambre de réaction, l'orifice d'aspiration (31) étant relié à une pompe d'évacuation d'air ou à un ventilateur (34).

13. Dispositif de réaction selon la revendication 11, une portion de liaison entre le dispositif de nettoyage (6) et le dispositif de support (3) ayant les mêmes structure et taille que la portion de liaison entre le support de substrat (8) et le dispositif de support(3).

14. Dispositif de réaction selon la revendication 11, le dispositif de nettoyage (6) comprenant en outre un dispositif de barrage (19) dont est munie la périphérie de la pluralité d'ensembles racleurs (62) et qui encercle la pluralité d'ensembles racleurs.

15. Dispositif de réaction selon la revendication 11, le dispositif de nettoyage (6) comprenant en outre une deuxième surface (63) en face d'une paroi intérieure latérale de la chambre de réaction, ladite deuxième surface (63) étant munie d'une pluralité d'ensembles racleurs (62).
